# EUROPÄISCHE PATENTSCHRIFT

(11) **EP 0 838 478 B1**
(45) Veröffentlichungstag und Bekanntmachung des Hinweises auf die Patenterteilung: **27.02.2002**
(21) Anmeldenummer: 97118533.5
(22) Anmeldetag: 24.10.1997
(51) Int. Cl.: C08F 8/28, C08F 8/32, G03F 7/021, G03F 7/033

(54) **Amidosubstituierte Acetalpolymere und Verwendung derselben in photoempfindlichen Zusammensetzungen und lithographischen Druckplatten**
Amido substituted acetal polymers and their use in photosensitive compositions and lithographic printing plates
Polyacétals amido-substitués et compositions photosensibles et plaques d'impression lithographiques les utilisant

(30) Priorität: 25.10.1996 DE 19644515
(43) Veröffentlichungstag der Anmeldung: 29.04.1998
(73) Patentinhaber: Kodak Polychrome Graphics LLC, Norwalk, Connecticut 06851 (US)
(72) Erfinder: Baumann, Harald, 37520 Osterode/Harz (DE); Dwars, Udo, 37520 Osterode/Harz (DE); Savariar-Hauck, Celin, 37520 Osterode/Harz (DE); Timpe, Hans-Joachim, 37520 Osterode/Harz (DE)
(74) Vertreter: VOSSIUS & PARTNER

(56) Entgegenhaltungen:
- EP-A- 0 208 145
- EP-A- 0 211 406
- EP-A- 0 752 430
- DE-A- 3 720 687
- DE-A- 19 525 050
- US-A- 5 086 111
- PATENT ABSTRACTS OF JAPAN vol. 007, no. 253 (P-235), 10.November 1983 & JP 58 137834 A (KURARAY KK), 16.August 1983,

## Beschreibung

Die Erfindung betrifft Bindemittel und lichtempfindliche Zusammensetzungen, die unter anderem ausgezeichnet zur Herstellung von Druckplatten geeignet sind.

An lichtempfindliche Zusammensetzungen, die insbesondere für hochleistungsfähige Druckplatten verwendbar sind, werden heutzutage hohe Anforderungen gestellt.

Zur Verbesserung der Eigenschaften lichtempfindlicher Zusammensetzungen und somit auch der entsprechenden Druckplatten werden im wesentlichen zwei Wege beschritten. Der eine befaßt sich mit der Verbesserung der Eigenschaften der lichtempfindlichen Komponenten in den Zusammensetzungen (Negativdiazoharze, Photoinitiatoren, Photopolymere etc.), der andere mit der Auffindung neuer polymerer Verbindungen ("Bindemittel"), die die physikalischen und mechanischen Eigenschaften der lichtempfindlichen Schichten steuern sollen. Insbesondere letzter Weg ist für Druckplatten von wesentlicher Bedeutung, weil das Verhalten im Entwicklungs- und Druckprozeß (wie Entwickelbarkeit, Farbannahmevermögen, Kratzfestigkeit, Auflagenbeständigkeit) entscheidend durch die polymeren Bindemittel beeinflußt wird. Auch die Lagerfähigkeit und die Lichtempfindlichkeit der Materialien wird durch solche polymeren Verbindungen beeinflußt.

Die polymeren Bindemittel weisen zur Erfüllung der umfangreichen Anforderungen verschiedene Strukturelemente auf, die sich auf einzelne Eigenschaften unterschiedlich auswirken können. So fördern hydrophile Strukturelemente wie Carboxylgruppen, Hydroxylgruppen u.ä. im allgemeinen eine gute Entwickelbarkeit der lichtempfindlichen Zusammensetzungen in wäßrig-alkalischen Entwicklern und sorgen z.T. für ausreichende Haftung auf polaren Substraten. Hydrophobe Strukturelemente erschweren dagegen die Entwickelbarkeit in den genannten Entwicklern, gewährleisten aber die für Druckplatten unbedingt nötige gute Annahme der Farben im Druckprozeß.

Auf Grund des breiten Anforderungsspektrums an die polymeren Bindemittel gibt es seit vielen Jahren umfangreiche Arbeiten zur Synthese und Einsatzoptimierung dieser Stoffe für lichtempfindliche Zusammensetzungen, vgl. z.B. H. Baumann und H.-J. Timpe: "Chemical Aspects of Offset Printing" in J. prakt. Chem./Chemiker-Zeitung **336** (1994) Seiten 377 - 389.

In EP-A-135 026, EP-A-186 156 und US-A-4 731 316 werden Bindemittelsysteme beschrieben, die aus Mischungen von verschiedenen Polymeren bestehen, die unterschiedliche hydrophile/hydrophobe Eigenschaften besitzen. Solche Mischungen haben aber den Nachteil, daß es sehr häufig durch Unverträglichkeiten der Stoffe zu Entmischungen bei der Schichtbildung kommt. Desweiteren beobachtet man Abscheidungen der hydrophoben Polymere im Entwicklungsschritt bei der Druckplattenverarbeitung, die zur Verschlammung in den Entwicklungsmaschinen und zur Wiederablagerung von dispergierten Schichtteilen auf der Oberfläche des lichtempfindlichen Materials führen können.

Weiterhin wurden verschiedene Copolymere aus wenig hydrophilen Monomeren wie Styren, Acrylsäureester, Methacrylsäureester u.ä. mit hydrophilen Comonomeren beschrieben. Beispiele solcher Comonomere sind Halbester von Maleinsäure (DE-A-31 30 987, DE-C-43 11 738, EP-B-71 881, EP-A-104 863), Itakonsäure (EP-A-397 375, US-A-5 260 161) und Acrylsäure bzw. Methacrylsäure (EP-A-487 343, US-A-4 304 832, US-A-4 123 276). Als nachteilig erwies sich bei solchen Polymeren der sehr enge Spielraum der für die Anwendung wichtigen Eigenschaften wie Schichthaftung, Entwickelbarkeit, Annahmevermögen für Druckfarben und Auflagenbeständigkeit. Herstellungsbedingt kann man Variationen der Polymerzusammensetzungen kaum vermeiden, was zu nicht akzeptablen Schwankungen in den Platteneigenschaften führt.

In DE-A-27 51 060 sind lichtempfindliche Zusammensetzungen beschrieben, bei denen das Bindemittel ein Umsetzungsprodukt von Celluloseestern mit cyclischen, intramolekularen Säureanhydriden von Dicarbonsäuren darstellt. Diese Bindemittel weisen jedoch eine zu geringe Oleophilie für die Anwendung in Druckplattenformulierungen auf. Außerdem entspricht ihre Auflagenbeständigkeit nicht den Anforderungen an eine moderne Druckplatte.

Als eine weitere Gruppe von Bindemitteln wurden Acetale von aliphatischen Aldehyden mit unsubstituierter niederer Alkylgruppe und Vinylalkohol/Vinylacetatcopolymeren beschrieben (US-A-2 179 051, EP-B-216 083). Derartige Bindemittel bereiten aber beim Entwickeln von Druckplatten infolge des zu geringen Anteils von hydrophilen Gruppen im Polymer Probleme. Zur Verbesserung wurden teilacetalisierte Vinylalkohol/Vinylacetatcopolymere durch spezielle Reaktionen mit hydrophilen oder alkalilöslichen Gruppierungen versehen. In DE-A-36 44 162 und EP-B-274 075 werden zur Acetalisierung neben Aldehyden mit hydrophoben Gruppen (z.B. Alkyl- oder Arylgruppen) hydroxylgruppenhaltige Aldehyde verwendet. Diese strukturelle Änderung führt aber nicht zu einer deutlichen Verbesserung der Entwickelbarkeit.

Zur Verbesserung der Entwickelbarkeit wurden in DE-A-20 53 363, DE-A-20 53 364 und EP-B1-48 876 Sulfonylurethangruppen in Polyvinylacetale eingeführt. Die geringe Acidität dieser Gruppen erfordert allerdings Entwickler mit einem hohen Lösungsmittelanteil. Außerdem weisen Mikroelemente so hergestellter Druckplatten eine sehr geringe Haftung auf, so daß sie im Druckprozeß zu schnell abgerieben werden.

In GB 1 396 355 und US-A-3 847 614 sind Bindemittel beschrieben, die sich durch Acetalisierung verseifter Copolymere aus Vinylacetat und einem carboxylgruppentragenden Monomeren wie Crotonsäure herstellen lassen. Diese Art von Bindemittel führt jedoch zu Systemen mit geringer Lichtempfindlichkeit und niedriger Auflagenbeständigkeit bei der Verwendung für Druckformen. Außerdem sind solche Zusammensetzungen in wäßrig-alkalischen Entwicklern schlecht entwickelbar, weil sich die Säurezahl der Bindemittel durch chemische Reaktionen der Carboxylgruppe während des Verseifungs- bzw. Acetalisierungsschrittes stark verringert.

In EP-B1-211 391 und EP-B1-152 819 werden die Carboxylgruppen durch Reaktion von Acetalen, die separat aus aliphatischen Aldehyden und Polyvinylalkohol hergestellt wurden, mit intramolekularen, cyclischen Säureanhydriden von Dicarbonsäuren eingeführt. Der notwendige Syntheseaufwand ist jedoch groß, da zusätzlich zur Acetalisierung die nur in aprotischen Lösungsmitteln mögliche Reaktion mit den Säureanhydriden kommt. Weiterhin ist die Lichtempfindlichkeit der aus diesem Bindemittel hergestellten Zusammensetzungen noch zu gering.

In EP-B1-208 145 sind Bindemittel beschrieben, die in einer dreistufigen Synthese ausgehend von Polyvinylalkohol hergestellt werden: Acetalisierung mit aliphatischen Aldehyden, Umsetzung mit intramolekularen, cyclischen Säureanhydriden von Dicarbonsäuren und teilweise Veresterung der Carboxylgruppen mit substituierten Alkylhalogeniden. Trotz des hohen Aufwandes bei der Bindemittelsynthese ist die Lichtempfindlichkeit der daraus hergestellten Schichten noch unbefriedigend, so daß eine Verbesserung wünschenswert ist.

Der Aufwand der mehrstufigen Synthesen kann vermieden werden, wenn, wie in WO 93/03068, US-A-4 652 604, US-A-4 895 788, US-A-4 940 646 und US-A-5 169 897 beschrieben, Polyvinylalkohol mit aliphatischen Aldehyden und carboxylgruppenhaltigen aliphatischen oder carboxylgruppenhaltigen aromatischen Aldehyden umgesetzt wird. Die daraus hergestellten lichtempfindlichen Zusammensetzungen weisen aber ein bezüglich Entwickelbarkeit und Empfindlichkeit ungünstiges Verhältnis auf.

Es werden auch Gemische aus Polyvinylacetalen und organischen Polymeren, die eine Säurezahl >71mg KOH/g besitzen müssen, beschrieben (EP-B-381 043). Hierbei kann es allerdings wieder zu Unverträglichkeiten und damit zu Entmischungen beim Beschichten oder Trocknen der lichtempfindlichen Zusammensetzungen kommen.

Urethangruppenhaltige Polymere wurden ebenfalls als Bindemittel für lichtempfindliche Zusammensetzungen beschrieben (EP-A2-415 302, EP-A1-406 599, EP-A1-406 600, EP-A2-414 099, US-A-4 983 491, US-A-4 950 582, US-A-4 877 711). Diese Polyurethanharze enthalten funktionelle Gruppen (-COOH, -SO₂NHCOO-, -CONHSO₂NH-) mit einem aciden Wasserstoffatom, deren pKₐ-Werte in Wasser nicht höher als 7 sind. Die Funktionalisierung mit solchen hydrophilen Gruppierungen erfordert allerdings einen sehr hohen Syntheseaufwand und führt zu hohen Kosten.

Trotz dieser intensiven Forschungen auf dem Gebiet lichtempfindlicher Zusammensetzungen für Druckplatten lassen alle bestehenden Zusammensetzungen noch Verbesserungen, insbesondere bezüglich ihrer Entwickelbarkeit und der Empfindlichkeit gegen Druckraumchemikalien, wünschenswert erscheinen. Auch weisen viele der Zusammensetzungen entweder eine hohe Anzahl von zum Teil teuren Bestandteilen auf, oder die Herstellung ihrer Hauptbestandteile ist mit einem hohen synthetischen Aufwand verbunden, was beides einem wirtschaftlichen Einsatz entgegensteht.

Es ist daher Aufgabe dieser Erfindung, Bindemittel für lichtempfindliche Zusammensetzungen bereitzustellen, deren Herstellung gegenüber den im Stand der Technik beschriebenen Bindemitteln mit einer möglichst geringen Zahl von Syntheseschritten auskommt, und die in lichtempfindlichen Zusammensetzungen dennoch die gleichen bzw. in einzelnen Bereichen verbesserte physikalische Eigenschaften aufweisen. Insbesondere soll gegenüber den im Stand der Technik beschriebenen Zusammensetzungen eine verbesserte Annahme der Druckfarbe und/oder eine höhere Druckauflage der entsprechenden Druckplatten erreicht werden. Eine gute Entwickelbarkeit in Entwicklern, die nur geringe Mengen an organischen Lösungsmitteln, Salzen und Netzmitteln enthalten, sowie eine hohe Lichtempfindlichkeit und gute Bildauflösungen, sollen dabei aber außerdem beibehalten bleiben; und darüber hinaus sollen die Zusammensetzungen mit den übrigen Produkten, die bei der Verarbeitung von Druckplatten verwendet werden, verträglich sein.

Eine weitere Aufgabe der Erfindung ist es, lichtempfindliche Zusammensetzungen bereitzustellen, die diese Bindemittel enthalten. Außerdem ist es die Aufgabe der Erfindung, solche lichtempfindlichen Zusammensetzungen zur Herstellung von Druckplatten zu verwenden.

Diese Aufgaben werden durch ein Bindemittel gelöst, enthaltend die Einheiten A, B, C und D, wobei A in einem Mengenanteil von 0,1 bis 25 Gew.-% vorliegt und der Formel 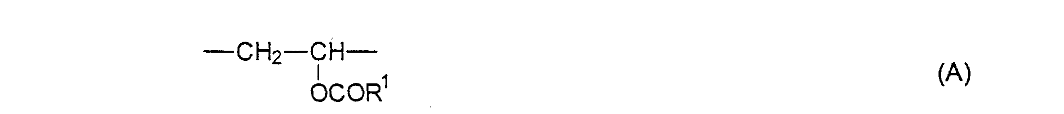 entspricht, in der R¹ ein Wasserstoffatom oder ein aliphatischer Kohlenwasserstoffrest mit 1 bis 4 Kohlenstoffatomen oder ein aromatischer Rest ist, B in einem Mengenanteil von 10 bis 50 Gew.-% vorliegt und der Formel 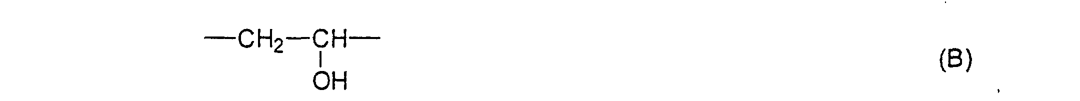 entspricht, C in einem Mengenanteil von 10 bis 80 Gew.-% vorliegt und der Formel 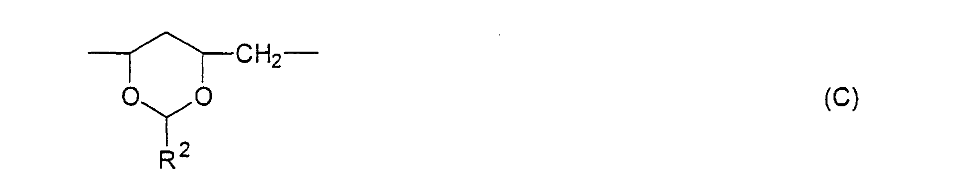 entspricht, in der R² ein Wasserstoffatom, ein Alkyl-, Aralkyl- oder Arylrest ist und diese Einheit mit verschiedenen Resten R² unabhängig voneinander mehrmals enthalten sein kann,
und D in einem Mengenanteil von 1 bis 40 Gew.-% vorliegt und der Formel 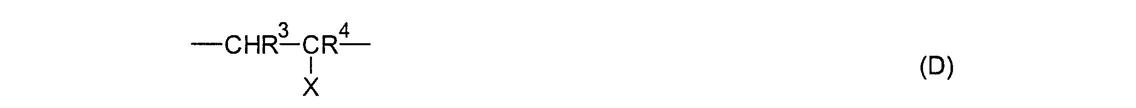 entspricht, in der X entweder die Gruppierung -NHCO-R⁵ oder -CO-NHR⁶ darstellt, und R³ und R⁴ Wasserstoffatome oder Alkylreste mit Kohlenstoffzahlen zwischen 1 und 10 sind,
R⁵ ein Wasserstoffatom oder ein aliphatischer gesättigter oder ungesättigter Kohlenwasserstoffrest mit 1 bis 10 Kohlenstoffatomen, der mit einer Carboxylgruppe substituiert sein kann, oder ein aromatischer Kohlenwasserstoffrest, der mit einer Carboxylgruppe und weiteren Substituenten substituiert sein kann, ist und
R⁶ ein Kohlenwasserstoffrest mit 1 bis 6 Kohlenstoffatomen, der durch eine oder mehrere Hydroxyl-, Ether- oder Amino-, Monoalkylamino-, Dialkylamino- oder Carboxylgruppen substituiert sein kann, wobei die Alkylreste der substituierten Aminogruppe oder der Ethergruppe 1 bis 3 Kohlenstoffatome enthalten, oder ein aromatischer Kohlenwasserstoffrest, der mindestens eine Carboxyl- oder Sulfonsäuregruppe, aber auch weitere Substituenten enthält, ist, und diese Einheit jeweils mit verschiedenen Resten R⁵ oder R⁶ unabhängig voneinander mehrmals enthalten sein kann.

Die Vorteile der Erfindung sind darin zu sehen, daß es durch sehr einfache Synthesen gelingt, ausgehend von kostengünstigen, großtechnisch verfügbaren Copolymeren, Bindemittel für lichtempfindliche Zusammensetzungen herzustellen. Die Eigenschaften der so erhältlichen Bindemittel können durch Variation der Molmasse und des Verseifungsgrades der Ausgangscopolymere, sowie der Art der Substituenten R¹ bis R⁶ sehr genau eingestellt werden. Dadurch lassen sich maßgeschneiderte Polymere erhalten, die für die Anwendung in lichtempfindlichen Zusammensetzungen basierend auf unterschiedlichen Photovernetzungsmechanismen geeignet sind. Die Entwickelbarkeit solcher Zusammensetzungen mit konventionellen Entwicklern, insbesondere solchen, die bei der Verarbeitung von Offsetdruckplatten Verwendung finden, konnte deutlich verbessert werden, ohne daß irgendwelche Farbannahmeprobleme auftreten. Außerdem sind solche Zusammensetzungen nach den normalen Verarbeitungsschritten für eine Offsetdruckplattenherstellung sehr abriebbeständig, und die Druckplatten können für Auflagen mit mehr als 300.000 Überrollungen verwendet werden.

Das erfindungsgemäße Bindemittel ist ein copolymerer Polyvinylalkohol, der eine direkt an die Hauptkette gebundene Säureamidgruppe enthält und dessen Hydroxyl-Gruppen teilweise acetalisiert werden. Die Struktur der zur Synthese solcher Produkte besonders bevorzugt verwendeten Ausgangsstoffe hängt davon ab, wie die Säureamidgruppe an die Hauptkette des Polyvinylalkohols gebunden ist.

Wenn die Säureamidgruppe über den Stickstoff mit der Hauptkette verbunden ist, d.h. X dem Strukturelement -NH-COR⁵ entspricht, werden vorzugsweise handelsübliche Polymere, die Vinylalkohol-, Vinylacetat- und Vinylamingruppen enthalten, eingesetzt. Aber auch Polymere, die Vinylbenzoat-gruppen (R¹ = C₆H₅) enthalten, die gegebenenfalls mit Alkyl- oder Alkoxygruppen substituiert sind, können verwendet werden. Die Umwandlung dieser Polymere in die erfindungsgemäßen Bindemittel geschieht in zwei Stufen.

In der ersten Stufe wird ausgehend von aminogruppenhaltigen Polymeren die Struktur -NH-COR⁵ erzeugt. Dazu wird vorzugsweise von Säurehalogeniden R⁵COX (X = Cl, Br), Carbonsäureanhydriden R⁵-CO-OCO-R⁵ oder intramolekularen, cyclischen Carbonsäureanhydriden der Formel I ausgegangen.

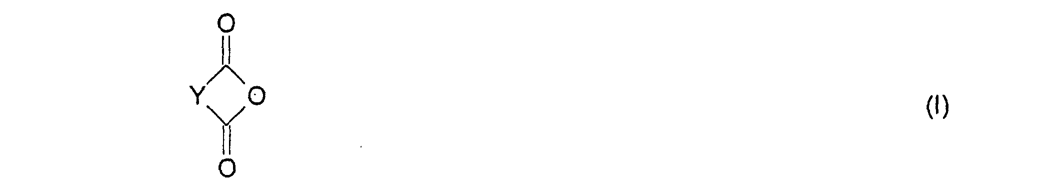

Die Umsetzung erfolgt vorzugsweise bei Temperaturen zwischen 10 und 60 °C in einem Lösungsmittel für das Ausgangspolymer. Bevorzugte Lösungsmittel sind Tetrahydrofuran, 1,4-Dioxan, 1,3-Dioxolan, Hexamethylphosphorsäuretriamid, N-Methylpyrrolidon, Formamid, N,N-Dimethylformamid, Dimethylsulfoxid, Mischungen aus Wasser und Isopropanol u.ä.. Zur Isolation des Produktes des ersten Syntheseschrittes in fester Form wird die Polymerlösung in einen Nichtlöser für das Polymer unter Rühren eingeleitet, abfiltriert und getrocknet. Als Nichtlöser für das Polymer sind unpolare Lösungsmittel geeignet. In den meisten Fällen wird man aber das Produkt nicht isolieren, sondern den Folgeschritt im gewählten Lösungsmittel anschließen.

Als Säurehalogenide R⁵COX (X = Cl, Br) oder Carbonsäureanhydride R⁵-CO-OCO-R⁵ werden Acetanhydrid (R⁵ = CH₃) und Benzoesäureanhydrid (R⁵ = C₆H₅) besonders bevorzugt eingesetzt.

Als intramolekulare, cyclische Carbonsäureanhydride der Formel I eignen sich zum Beispiel die folgenden Verbindungen: Maleinsäureanhydrid und dessen Derivate (wie Dimethylmaleinsäureanhydrid oder Citraconsäureanhydrid), Phthalsäureanhydrid und dessen Substitutionsprodukte (wie Chlor-, Nitro- oder Carboxyphthalsäureanhydrid) oder Hydrierungsprodukte (wie Tetrahydrophthalsäureanhydrid), Bernsteinsäureanhydrid und Derivate (wie Methylbernsteinsäureanhydrid), Glutarsäureanhydrid und Derivate (wie 3-Oxaglutarsäureanhydrid, 3-Methylglutarsäureanhydrid, 3,3-Tetramethylenglutarsäureanhydrid oder Campfersäureanhydrid), Naphthalindicarbonsäureanhydride und deren Substitutionsprodukte (wie Naphthalin-2,3-dicarbonsäureanhydrid oder Naphthaiin-1,8-dicarbonsäureanhydrid), Pyridin-2-carbonsäureanhydrid und dessen Substitutionsprodukte, Pyrazin-2-carbonsäureanhydrid und dessen Substitutionsprodukte, Furan-2-carbonsäureanhydrid und dessen Substitutionsprodukte, Thiophen-2-carbonsäureanhydrid und Thiophen-2,5-dicarbonsäureanhydrid, dessen Substitutionsprodukte sowie dessen ganz oder teilweise hydrierte Derivate und di- oder polycyclische Anhydride, die durch Diels-Alder-Reaktion eines Diens mit Maleinsäureanhydrid entstehen (wie Additionsprodukte aus Furan, Anthracen, Cyclohexadien-1,3, oder Cyclopentadien).

Besonders bevorzugt sind Malein-, Phthal-, Tetrahydrophthal-, Bernstein- und 3-Oxaglutarsäureanhydrid.

Für bestimmte Anwendungen kann es von Vorteil sein, zwei verschiedene Gruppierungen -NH-COR⁵ in das Polymer einzuführen. So kann man beispielsweise durch die Wahl des molaren Verhältnisses von Anhydrid R⁵CO-OCO-R⁵ zu intramolekularem cyclischem Carbonsäureanhydrid der Formel I eine gewünschte Säurezahl im Polymer einfach einstellen.

In der zweiten Stufe der Herstellung der erfindungsgemäßen Polymere werden die vorstehend genannten polymeren Säureamide mit Aldehyden teilweise acetalisiert. Diese Umsetzung geschieht nach bekannten Standardverfahren für die Polyvinylacetalsynthese in Gegenwart katalytischer Mengen einer Mineralsäure; Beispiele sind beschrieben in EP-B-216 083 und DE-B-2 838 025.

Die Acetalreste R² lassen sich ausgehend von Aldehyden R²CHO oder Acetalen dieser Aldehyde R²CH(OR⁷)₂ in das Polymermolekül einführen, wobei R⁷ einen niederen Alkylrest darstellt. Der Rest R² ist ein verzweigter oder unverzweigter Alkylrest mit vorzugsweise 1 bis 10 Kohlenstoffatomen oder ein aromatischer Rest (beispielsweise R² = C₆H₅), der gegebenenfalls mit Methyl-, Carboxyl- oder Methoxygruppen substituiert sein kann. Besonders bevorzugt ist die Synthese ausgehend von Acetaldehyd, Propionaldehyd und Butyraldehyd bzw. deren Acetalen mit niederen Alkoholen R⁷OH.

Die Umsetzung kann entweder in dem Lösungsmittel der ersten Stufe oder in einem organischen Lösungsmittel, das für Vinylalkohol/Vinylacetatcopolymere beschrieben ist (vgl. dazu Broschüre Mowiol® -Polyvinylalkohol, Hoechst AG, 1991, Seite C13), besonders bevorzugt Dimethylsulfoxid, bzw. in Wasser in Gegenwart eines Tensids oder in einem Gemisch aus Wasser und einem hydroxylgruppenhaltigen Lösungsmittel wie Ethanol, n-Propanol oder iso-Propanol, besonders bevorzugt ist eine n-Propanol/Wasser-Mischung (2:1 Gew.-Teile), erfolgen. Die Reaktion wird üblicherweise bei Temperaturen zwischen 0 und 80 °C durchgeführt. Die Konzentration der Reaktionspartner bezogen auf die Lösungsmittelmenge beträgt 3 bis 25 Gew.-%, besonders bevorzugt sind 7 bis 16 Gew.-%. Die katalytische Menge an zugegebener Mineralsäure liegt zwischen 1 bis 15 Gew.-% bezogen auf die Gesamtmenge der Reaktionspartner. Die Menge an Mineralsäure kann, muß aber nicht zwingend, nach Beendigung der Reaktion durch Zugabe molarer Mengen eines alkalischen Salzes wie beispielsweise Natrium- und Kaliumcarbonat neutralisiert werden, um eine sauer katalysierte Hydrolyse bzw. Acetalspaltung der polymeren Bindemittel bei der Lagerung oder späteren Anwendung zu verhindern. Natrium- oder Kaliumhydroxid sind ebenfalls zum Neutralisieren geeignet.

Bei geeigneter Wahl des Lösungsmittels kann man erreichen, daß das Endprodukt in dem Lösungsmittel unlöslich ist und ausfällt. In einer anderen Ausführungsform wird zur Isolation des Acetalisierungsproduktes in fester Form die Polymerlösung in einen Nichtlöser für das Polymer unter Rühren eingeleitet, abfiltriert und getrocknet. Als Nichtlöser für das Polymer ist Wasser besonders geeignet. Eine andere, ebenfalls praktikable Verfahrensweise ist es, den Nichtlöser für das Polymer unter Rühren in die Syntheselösung zu geben. Auch bei diesem Verfahren ist Wasser ein bevorzugter Nichtlöser. In beiden Fällen muß intensiv durchmischt werden, um ein gut handhabbares Umsetzungsprodukt zu erhalten und die mitentstehenden Nebenprodukte möglichst quantitativ abzutrennen. Das ausgefallene Reaktionsprodukt wird abgetrennt, mit Wasser gewaschen und anschließend mit Warmluft von 30 bis 70 °C getrocknet.

Wenn die Anbindung der Säureamidgruppe an die Polymerhauptkette über den Carbonylkohlenstoff erfolgt, d.h. X dem Strukturelement -CO-NHR⁶ entspricht, dienen Copolymere zwischen Vinylestern und ungesättigten Carbonsäuren als Ausgangsprodukte für die Herstellung der erfindungsgemäßen Polymere. Bevorzugter Vinylester ist Vinylacetat (führt im erfindungsgemäßen Polymer zu R¹ = CH₃), aber auch Vinylbenzoat (ergibt R¹ = C₆H₅) oder dessen Substitutionsprodukte mit Alkyl- oder Alkoxygruppen sind verwendbar. Besonders bevorzugte Comonomere für die Vinylester sind Acryl-, Methacryl-, Croton-, Vinylessig-, Itacon- und Maleinsäure. Der wünschenswerte Anteil carboxylgruppenhaltiger Monomere im Polymermolekül und die gewichtsgemittelte Molmasse der Polymere hängen vom späteren Verwendungszweck der lichtempfindlichen Zusammensetzung ab. Sollen die Zusammensetzungen zur Herstellung von Offsetdruckplatten verwendet werden, sind Comonomeranteile, die zu einer Säurezahl von 10 bis 90 mg KOH/g führen, bevorzugt, die polymeren Bindemittel haben dann eine gewichtsgemittelte Molmasse M_{w} von 20.000 bis 130.000 g/Mol.

Die Umwandlung dieser Copolymere in die erfindungsgemäßen Polymere geschieht durch die Reaktionsfolge: Verseifung - Acetalisierung - Aminolyse.

Die Verseifung der Copolymere erfolgt nach bekannten Standardverfahren; Beispiele sind beschrieben in K. Noro, "Polyvinylalcohol Properties and Applications" (Herausgeber: C. A. Finch), John Wiley & Sons, London 1973. Im vorliegenden Fall ist sowohl eine sauer katalysierte als auch eine alkalisch katalysierte Verseifung, letztere wie in GB-1 396 355 beschrieben und in methanolischer Lösung mit Natriummethylat ausgeführt, anwendbar, ohne daß die Eigenschaften der lichtempfindlichen Zusammensetzung wesentlich beeinflußt werden. Eine saure Verseifung ist vorzuziehen, da dann das Verseifungsprodukt nicht isoliert werden muß, sondern die Lösung gleich zur Acetalisierung verwendet werden kann. Außerdem kann der Hydrolysegrad der Vinylestergruppe im Copolymer auf diesem Wege, vor allem über die angewendete Reaktionstemperatur und die Reaktionszeit, variiert werden. Bei Temperaturen zwischen 30 und 50 °C oder verkürzten Reaktionszeiten werden zu wenig Vinylestergruppen verseift. Geringere Hydrolysegrade führen zu Polymeren, aus denen nach Acetalisierung und Aminolyse Bindemittel erhalten werden, die sich nur noch schlecht entwickeln lassen. Hydrolysegrade zwischen 75 und 98 Gew.-% sind zur Herstellung der erfindungsgemäßen polymeren Bindemittel besonders bevorzugt. Die verseiften Copolymere können durch Einrühren in niedere Alkohole wie Methanol oder Ethanol isoliert werden.

Überraschenderweise besitzen die nach beiden Verfahrensweisen, d.h. durch eine alkalische oder saure Verseifung, hergestellten Produkte eine Säurezahl von null Analytische Untersuchungen haben gezeigt, daß die Carboxylgruppen unter den genannten Verseifungsbedingungen bevorzugt Lactone mit den OH-Gruppen der Polymere bilden.

In der zweiten Stufe der Herstellung der erfindungsgemäßen polymeren Bindemittel mit dem Strukturelement -CONHR⁶ werden die vorstehend genannten Verseifungsprodukte mit Aldehyden oder Acetalen dieser Aldehyde R²CH(OR⁷)₂ zu Polyvinylacetalen umgesetzt. Diese Umsetzung geschieht nach den weiter oben für die polymeren Säureamide mit dem Strukturelement -NHCO-R⁵ beschriebenen Prozeduren. Als Lösungsmittel sind in diesem Fall Mischungen aus Alkoholen und Wasser bevorzugt.

Die Reste R² sind wie bei den erfindungsgemäßen polymeren Säureamiden mit dem Strukturelement -NHCO-R⁵ angegeben definiert. Als Aldehyd R²CHO für die Acetalisierung der verseiften Copolymere werden Acetaldehyd, Propionaldehyd oder Butyraldehyd bzw. deren Acetale mit niederen Alkoholen allerdings bevorzugt. Besonders bevorzugt ist Propionaldehyd. Im allgemeinen wird die Entwickelbarkeit lichtempfindlicher Zusammensetzungen aus den erfindungsgemäßen polymeren Bindemitteln mit steigender Menge an eingesetztem aliphatischen Aldehyd oder mit dessen steigender Kohlenstoffzahl verschlechtert. Aber auch der Hydrolysegrad, der bei der Verseifung erreicht wird, und die Molmasse des Ausgangscopolymers sowie die Substituenten R⁶ am N-Atom bestimmen die Entwickelbarkeit solcher Zusammensetzungen.

Zur Einführung von Einheiten C mit unterschiedlichen Alkylresten ist die Verwendung eines Gemisches der oben genannten aliphatischen Aldehyde oder deren Acetale möglich, aber nicht zwingend notwendig, wodurch insbesondere die Entwickelbarkeit der lichtempfindlichen Zusammensetzungen sehr fein abgestimmt werden kann.

Zur Minimierung des Syntheseaufwandes kann die Verseifungs- und Acetalisierungstufe ohne Isolierung des Verseifungsproduktes durchgeführt werden. Man verwendet dann die oben angeführten Gemische von Wasser mit organischen Lösungsmitteln und die für die Acetalisierung notwendigen Mengen an Säuren, löst die Copolymere auf und verseift sie in Abwesenheit der Aldehyde. Anschließend werden die Aldehyde zugefügt und die Acetalisierung ausgeführt. Die notwendigen Reaktionszeiten und -temperaturen für die Verseifung sind vom gewünschten Verseifungsgrad abhängig. Bevorzugt sind einheitliche Reaktionstemperaturen für die Verseifung und Acetalisierung. Es ist auch eine simultane Verseifung und Acetalisierung möglich, d.h. die Aldehyde werden von Anfang an zugegeben. Auf diese Weise sind aber nur Polyvinylacetale mit einem niedrigen Acetalisierungsgrad erhältlich.

Die nach dem oben beschriebenen Verfahren hergestellten Polyvinylacetale besitzen ebenfalls eine Säurezahl von null.

In der dritten Stufe der Herstellung der erfindungsgemäßen polymeren Bindemittel mit dem Strukturelement -CO-NHR⁶ werden die vorstehend genannten Polyvinylacetale mit substituierten primären Aminen umgesetzt. Die Umsetzung erfolgt in einem organischen Lösungsmittel, das beide Produkte gut löst, üblicherweise innerhalb von 3 bis 5 Stunden durch Erhitzen auf 40 bis 80 °C. Besonders geeignete Lösungsmittel sind Alkohole (wie Methanol, Ethanol, Propanol, Butanol oder Glykolether), cyclische Ether (wie Tetrahydrofuran, 1,4-Dioxan, 1,3-Dioxolan) oder dipolare aprotische Lösungsmittel (wie Dimethylsulfoxid). Die Reaktionszeiten können durch Zugabe von katalytischen Mengen an Säuren, besonders bevorzugt ist dabei 4-Toluolsulfonsäure, auf 1 bis 2 Stunden erniedrigt werden. Zur Isolation der erfindungsgemäßen Polymere werden die für die Polyvinylacetalisierung genannten Ausfällungsprozeduren verwendet. Als Nichtlöser ist auch in diesem Fall Wasser besonders geeignet.

Die für die Synthese der erfindungsgemäßen Polymere notwendigen substituierten primären Amine sind wie oben angegeben definiert. Es handelt sich durchweg um handelsübliche Produkte. Typische Verbindungen sind Methylamin, Monoethanolamin, 3-Hydroxypropylamin, 4-Aminobuttersäure, 5-Aminocapronsäure, 4-Aminobenzoesäure, 3-Aminobenzoesäure, 4-Aminobenzolsulfonsäure. Das sind aber nicht ausschließliche Beispiele für Reaktionspartner zur Aminolyse der Polyvinylacetale. Die mit den vorstehend genannten Aminen erhaltenen Bindemittel sind lediglich besonders bevorzugte Polymere für lichtempfindliche Zusammensetzungen, die zur Herstellung von Offsetdruckplatten geeignet sind. Die Menge an eingesetztem Amin richtet sich nach dem Molanteil des ungesättigten Carbonsäurecomonomers im Ausgangsvinylestercopolymer. Sie wird so gewählt, daß das Molverhältnis dieses Monomers und des Amins zwischen 0,5 bis 1,1 (bezogen auf Amin) liegt. Höhere Aminmengen führen zu einer deutlichen Decarboxylierung der Vinylestereinheit.

Die unter Verwendung von mit Carboxyl- oder Sulfonsäuregruppen substituierten Aminen erhaltenen Polymere besitzen eine Säurezahl verschieden von 0. Die Säurezahl der Bindemittel hängt wesentlich von der Säurezahl des Ausgangscopolymers, vom Molverhältnis der Reaktionspartner in der Aminolysestufe und von der Struktur des Amins ab. Solche Bindemittel verleihen lichtempfindlichen Zusammensetzungen eine besonders günstige Entwickelbarkeit.

Die drei Stufen der Herstellung der erfindungsgemäßen Bindemittel mit dem Strukturelement -CO-NHR⁶ können auch ohne Isolierung der jeweiligen Zwischenstufen ausgeführt werden. Dazu muß der Säuregehalt des Reaktionsmediums in der Aminolysestufe so weit abgesenkt werden, daß das eingesetzte Amin nicht vollständig protoniert vorliegt. Bei Verwendung von wäßrigalkoholischen Lösungsmitteln und Aminocarbonsäuren als Aminkomponente ist das überwiegend bei pH-Werten zwischen 3 bis 5 der Fall.

Neben dem erfindungsgemäßen Bindemittel gibt es einen zweiten wesentlichen Bestandteil der erfindungsgemäßen lichtempfindlichen Zusammensetzung, nämlich ein Diazoniumpolykondensationsprodukt oder ein radikalisch polymerisierbares System, bestehend aus Photoinitiatoren und ungesättigten Verbindungen, die radikalisch polymerisierbar sind, oder ein Hybridsystem bestehend aus einem Diazoniumpolykondensationsprodukt und einem radikalisch polymerisierbaren System bestehend aus Photoinitiatoren und ungesättigten Verbindungen, die radikalisch polymerisierbar sind.

Als Diazoniumpolykondensationsprodukt können in den erfindungsgemäßen lichtempfindlichen Zusammensetzungen dem Fachmann bekannte Diazoniumpolykondensationsprodukte verwendet werden. Solche Kondensationsprodukte können beispielsweise auf übliche Weise durch Kondensation eines in EP-A-0 104 863 beschriebenen Diazomonomers mit einem Kondensationsmittel, wie Formaldehyd, Acetaldehyd, Propionaldehyd, Butyraldehyd, Isobutyraldehyd oder Benzaldehyd hergestellt werden. Weiterhin werden Mischkondensationsprodukte verwendet, die außer den Diazoniumsalzeinheiten noch andere, nicht lichtempfindliche Einheiten enthalten, die von kondensationsfähigen Verbindungen, insbesondere aromatischen Aminen, Phenolen, Phenolethern, aromatischen Thioethern, aromatischen Kohlenwasserstoffen, aromatischen Heterocyclen und organischen Säureamiden, abgeleitet sind. Besonders vorteilhafte Beispiele der Diazoniumpolykondensationsprodukte sind Umsetzungsprodukte von Diphenylamin-4-diazoniumsalzen, die gegebenenfalls eine Methoxygruppe in dem die Diazogruppe tragenden Phenylrest enthalten, mit Formaldehyd oder 4,4'-Bis-methoxymethyldiphenylether. Als Anion dieser Diazoharze eignen sich im besonderem Maße aromatische Sulfonate, wie 4-Tolylsulfonat oder Mesitylensulfonat, Tetrafluoroborat, Hexafluoroantimonat, Hexafluoroarsenat oder Hexafluorophosphat. Das Diazoniumpolykondensationsprodukt ist vorzugsweise in einem Anteil von 3 bis 60 Gew.-% in den lichtempfindlichen Zusammensetzungen vorhanden.

Die richtige Zusammensetzung des erfindungsgemäßen Polymers, hergestellt nach einem der beiden oben beschriebenen Hauptverfahren, erfordert Optimierungsversuche für den jeweiligen Anwendungszweck. In der dem Fachmann bekannten Weise wird die Entwickelbarkeit, die Photoempfindlichkeit, das Annahmevermögen für Farben, die Stabilität bei Lagerung unter erhöhter Luftfeuchtigkeit und Temperatur usw. in Abhängigkeit von der Zusammensetzung des Polymers ermittelt.

Ist der zweite wesentliche Bestandteil ein radikalisch polymerisierbares System, so setzt sich dieses zusammen aus Photoinitiatoren, die bevorzugt im Bereich von 300 bis 800 nm, besonders bevorzugt von 300 bis 450 nm absorbieren, und radikalisch polymerisierbaren Bestandteilen. Als Photoinitiatoren für die erfindungsgemäßen lichtempfindlichen Zusammensetzungen eignen sich bevorzugt die Grundkörper bzw. Derivate von Acetophenon, Benzophenon, 2,4-(Trichlormethyl)-1,3,5-triazin, Benzoin, Benzoinethern, Benzoinketalen, Xanthon, Thioxanthon, Acridin oder Hexaarylbisimidazol. Der radikalisch polymerisierbare Bestandteil der erfindungsgemäßen Zusammensetzung ist ein Acryl- oder Methacrylsäurederivat mit einer oder mehreren ungesättigten Gruppen, vorzugsweise Ester der Acryl- oder Methacrylsäure in Form von Monomeren, Oligomeren oder Prepolymeren. Er kann in fester oder flüssiger Form vorliegen, wobei feste und zähflüssige Formen bevorzugt sind. Zu den Verbindungen, die als Monomere geeignet sind, zählen beispielsweise Trimethylolpropantriacrylat und -methacrylat, Pentaerythrittriacrylat und -methacrylat, Dipentaerythritmonohydroxypentaacrylat und -methacrylat, Dipentaerythrithexaacrylat und -methacrylat, Pentaerythrittetraacrylat und -methacrylat, Ditrimethylolpropantetraacrylat und -methacrylat, Diethylenglykoldiacrylat und -methacrylat, Triethylenglykoldiacrylat und -methacrylat oder Tetraethylenglykoldiacrylat und -methacrylat. Geeignete Oligomere bzw. Prepolymere sind Urethanacrylate und -methacrylate, Epoxidacrylate und -methacrylate, Polyesteracrylate und -methacrylate, Polyetheracrylate und -methacrylate oder ungesättigte Polyesterharze. Die Photoinitiatoren und radikalisch polymerisierbaren Bestandteile sind in der dem Fachmann bekannten Weise zusammenzusetzen, wobei auch Kombinationen verschiedener Photoinitiatoren und unterschiedlicher radikalisch polymerisierbarer Komponenten von Vorteil sind. Vorzugsweise ist der Gewichtsanteil der Photoinitiatoren 0,5 bis 20 Gew.-% und der der radikalisch polymerisierbaren Bestandteile 5 bis 80 Gew.-% bezogen auf den Gesamtfeststoffgehalt der lichtempfindlichen Zusammensetzungen.

Eine Kombination der Diazoniumpolykondensationsprodukte mit einem radikalisch polymerisierbaren System bestehend aus Photoinitiatoren und ungesättigten Verbindungen, die radikalisch polymerisierbar sind, kann für bestimmte Anwendungen Vorteile bringen. Solche Hybridsysteme bestehen vorzugsweise aus 1 bis 50 Gew.-% Diazoniumpolykondensationsprodukt, 0,5 bis 20 Gew.-% der Photoinitiatoren sowie 5 bis 80 Gew.-% der radikalisch polymerisierbaren Bestandteile, bezogen auf die lichtempfindliche Zusammensetzung.

Die in den erfindungsgemäßen lichtempfindlichen Zusammensetzungen verwendbaren Belichtungsindikatoren sind dem Fachmann bekannt. Bevorzugt sind Belichtungsindikatoren aus der Reihe der Triarylmethanfarbstoffe (wie Viktoriareinblau BO, Viktoriablau R, Kristallviolett) oder Azofarbstoffe (wie 4-Phenylazodiphenylamin oder 4-N,N-Dimethylaminoazobenzol). Die Belichtungsindikatoren sind in der lichtempfindlichen Zusammensetzung in einem Anteil von 0,02 bis 10 Gew.-%, bevorzugt 0,1 bis 6 Gew.-% vorhanden.

Als Farbstoffe zur Erhöhung des Bildkontrastes eignen sich solche, die sich gut in dem zur Beschichtung verwendeten Lösungsmittel oder Lösungsmittelgemisch lösen oder als Pigment in disperser Form eingebracht werden können. Zu den geeigneten Kontrastfarbstoffen gehören u.a. Rhodaminfarbstoffe, Methylviolett, Anthrachinonpigmente und Phthalocyaninfarbstoffe bzw. -pigmente. Die Farbstoffe sind in der lichtempfindlichen Zusammensetzung in einem Anteil von 1 bis 15 Gew.-%, bevorzugt 2 bis 10 Gew.-% enthalten.

Weiterhin kann die erfindungsgemäße Zusammensetzung Stabilisatorsäuren enthalten. Solche stabilisierenden Säuren sind u.a. Phosphor-, Citronen-, Benzoe-, m-Nitrobenzoe-, p-Anilinoazobenzolsulfon-, p-Toluolsulfon- oder Weinsäure. Vorteilhaft ist bei manchen Formulierungen ein Gemisch aus mehreren verschiedenen Säuren. Phosphorsäure wird bevorzugt als stabilisierende Säure verwendet. Der Anteil der zugegebenen Säure beträgt vorzugsweise 0,2 bis 3 Gew.-%.

Die erfindungsgemäße lichtempfindliche Zusammensetzung kann ferner einen Weichmacher enthalten. Geeignete Weichmacher sind u.a. Dibutylphthalat, Triarylphosphat und Dioctylphthalat. Dioctylphthalat ist besonders bevorlugt. Die Einsatzmengen an Weichmacher sind vorzugsweise 0,25 bis 2 Gew.-%.

Die erfindungsgemäßen lichtempfindlichen Zusammensetzungen sind vorzugsweise zur Herstellung von Druckplatten verwendbar. Weiterhin können sie jedoch auch bei Aufzeichnungsmaterialen zur Herstellung von Bildern auf geeigneten Trägern und Empfangsblättern, zur Herstellung von Reliefs, die als Druckform, Siebe und dgl. verwendbar sind, als lichthärtbare Lacke zum Oberflächenschutz und zur Formulierung von UV-härtbaren Druckfarben eingesetzt werden.

Zur Herstellung von Flachdruckplatten wird Aluminium als Schichtträger zunächst durch Bürsten im trockenen Zustand, Bürsten mit Schleifmittel-Suspensionen oder auf elektrochemischem Wege, z.B. in einem Salzsäurelektrolyten, aufgerauht. Die aufgerauhten und gegebenenfalls anodisch in Schwefel- oder Phosphorsäure oxydierten Platten werden anschließend einer hydrophilisierenden Nachbehandlung vorzugsweise in wäßrigen Lösungen von Polyvinylphosphonsäure, Natriumsilikat oder Phosphorsäure unterworfen. Die Details der o.g. Substratvorbehandlung sind dem Fachmann hinlänglich bekannt.

Die anschließend getrockneten Substrate werden mit den lichtempfindlichen Zusammensetzungen aus organischen Lösemitteln bzw. Lösemittelgemischen so beschichtet, daß Trockenschichtgewichte vorzugsweise im Bereich von 0,5 bis 4 g/m², besonders bevorzugt 0,8 bis 3 g/m², erhalten werden.

In einigen Fällen kann das zusätzliche Aufbringen einer sauerstoffsperrenden Deckschicht auf die lichtempfindliche Schicht von Vorteil sein. Dies ist besonders bei radikalisch polymerisierbaren Systemen und bei den Hybridsystemen aus Diazoniumpolykondensationsprodukt und radikalisch polymerisierbaren Systemen günstig. Zu den für die Deckschicht geeigneten Polymeren gehören u.a. Polyvinylalkohol, Polyvinylalkohol/Polyvinylacetatcopolymere, Polyvinylpyrrolidon, Polyvinylpyrrolidon/Polyvinylacetatcopolymere, Polyvinylmethylether, Polyacrylsäure und Gelatine. Die Schichtdicken der sauerstoffsperrenden Deckschicht betragen vorzugsweise 0,1 bis 4 g/m², und ganz besonders bevorzugt 0,3 bis 2 g/m².

Die so hergestellten Druckplatten werden in der dem Fachmann bekannten Weise belichtet und entwickelt. Die entwickelten Platten werden üblicherweise mit einem Konservierungsmittel ("Gummierung") behandelt. Die Konservierungsmittel bestehen aus wäßrigen Lösungen von hydrophilen Polymeren, Netzmitteln und weiteren Zusätzen.

Es ist weiterhin günstig, für bestimmte Anwendungen die mechanische Festigkeit der druckenden Schichten durch eine Wärmebehandlung oder kombinierte Anwendung von Wärme und UV-Licht zu erhöhen. Dazu wird vor dieser Behandlung die fertig entwickelte Platte zunächst mit einer Lösung behandelt, die die Nichtbildstellen so schützt, daß die Wärmebehandlung keine Farbannahme dieser Bereiche hervorruft. Eine hierfür geeignete Lösung ist z.B. in US-A-4 355 096 beschrieben.

Die Erfindung wird mit den nachfolgenden Beispielen näher erläutert.

### Herstellungsbeispiel 1

10 g eines Copolymers aus 96 mol-% Vinylalkohol und 4 mol-% Vinylamin (Molekulargewicht 36.000 g/Mol) werden in 80 ml DMSO bei 60°C gelöst. Anschließend wird auf 10°C abgekühlt und 0,7 g Maleinsäureanhydrid (gelöst in 10 ml DMSO) und 0,9 g Essigsäureanhydrid (gelöst in 10 ml DMSO) langsam zugetropft. Nach beendeter Zugabe wird die Mischung 30 min auf 50°C erwärmt. Dann werden nacheinander 2,5 ml konzentrierte Salzsäure (37 Gew.-%), 2,4 g Acetaldehyd und 3,9 g Butyraldehyd, zusammen gelöst in 10 ml DMSO im Verlaufe von 30 min zugetropft. Nach beendeter Zugabe rührt man 1 Stunde bei 50 °C und läßt auf Raumtemperatur abkühlen. Das Polymer wird in Wasser ausgefällt, neutral gewaschen und 24 Stunden bei 40 °C im Umlufttrockenschrank getrocknet. Die ermittelte Säurezahl beträgt 27 mg KOH/g.

### Herstellungsbeispiel 2

10 g eines Copolymers aus 96 mol-% Vinylalkohol und 4 mol-% Vinylamin (Molekulargewicht 36.000 g/Mol) werden in 80 ml DMSO bei 60°C gelöst. Anschließend wird auf 10 °C abgekühlt und 0,7 g Maleinsäureanhydrid (gelöst in 10 ml DMSO) und 2,2 g Benzoesäureanhydrid (gelöst in 10 ml DMSO) langsam zugetropft. Nach beendeter Zugabe wird die Mischung 30 min auf 50 °C erwärmt. Dann werden nacheinander 2,5 ml konzentrierte Salzsäure (37 Gew.-%), 1,44 g Acetaldehyd und 2,35 g Butyraldehyd, zusammen gelöst in 10 ml DMSO im Verlaufe von 30 min zugetropft. Nach beendeter Zugabe rührt man 1 Stunde bei 50 °C und läßt auf Raumtemperatur abkühlen. Das Polymer wird in Wasser ausgefällt, neutral gewaschen und 24 Stunden bei 40 °C im Umlufttrockenschrank getrocknet. Die ermittelte Säurezahl beträgt 25 mg KOH/g.

### Herstellungsbeispiel 3

10 g eines Copolymers aus 96 mol-% Vinylalkohol und 4 mol-% Vinylamin (Molekulargewicht 36.000 g/Mol) werden in 80 ml DMSO bei 60°C gelöst. Anschließend wird auf 10°C abgekühlt und 0,7 g Maleinsäureanhydrid (gelöst in 10 ml DMSO) und 0,9 g Benzoesäureanhydrid (gelöst in 10 ml DMSO) langsam zugetropft. Nach beendeter Zugabe wird die Mischung 30 min auf 50°C erwärmt. Dann werden nacheinander 2,5 ml konzentrierte Salzsäure (37 Gew.-%), und 5 g Butyraldehyd in 10ml DMSO im Verlaufe von 30 min zugetropft. Nach beendeter Zugabe rührt man 1 Stunde bei 50 °C und läßt auf Raumtemperatur abkühlen. Das Polymer wird in Wasser ausgefällt, neutral gewaschen und 24 Stunden bei 40 °C im Umlufttrockenschrank getrocknet. Die ermittelte Säurezahl beträgt 28 mg KOH/g.

### Herstellungsbeispiel 4

10 g eines Copolymers aus 96 mol-% Vinylalkohol und 4 mol-% Vinylamin (Molekulargewicht 36.000 g/Mol) werden in 160 ml n-Propanol bei 60°C gelöst.

Anschließend wird auf 10 °C abgekühlt und 0,7 g Maleinsäureanhydrid sowie 0,9 g Essigsäureanhydrid, zusammen in 10 ml Tetrahydrofuran gelöst, langsam zugetropft. Nach beendeter Zugabe wird die Mischung 30 min auf 50 °C erwärmt. Dann werden nacheinander 2 ml konzentrierte Salzsäure (37 Gew.-%), 5 g Butyraldehyd in 10 ml n-Propanol im Verlaufe von 30 min zugetropft. Nach beendeter Zugabe rührt man 1 Stunde bei 50 °C und läßt auf Raumtemperatur abkühlen. Das Polymer wird in Wasser ausgefällt, neutral gewaschen und 24 Stunden bei 40 °C im Umlufttrockenschrank getrocknet. Die ermittelte Säurezahl beträgt 30 mg KOH/g.

### Herstellungsbeispiel 5

### (Vorstufe für Herstellungsbeispiele 6 bis 8; nach GB-1 396 355)

50 g Mowilith Ct5 ® (Vinylacetat/Crotonsäurecopolymer der Fa. Hoechst mit einem Anteil an Crotonsäureeinheiten von 6 Gew. % und einer Säurezahl von etwa 40 mg KOH/g) werden in 450 ml wasserfreiem Methanol durch Erhitzen vollständig aufgelöst. Anschließend wird eine Lösung, bereitet aus 1 g metallischem Natrium und 20 ml wasserfreiem Methanol, zugefügt und das Gemisch unter Feuchtigkeitsausschluß weitere 30 min zum Kochen erhitzt. Der ausgefallene Niederschlag wird abgesaugt, mit wenig Methanol gewaschen und bei Raumtemperatur getrocknet. Das erhaltene Produkt wird mit Hilfe üblicher Verfahren bezüglich seines Gehaltes an Vinylalkoholeinheiten bzw. Carboxylgruppen untersucht. Es ergibt sich ein Vinylalkoholgehalt von 74 Gew.-% und eine Säurezahl von 0 mg KOH/g.

### Herstellungsbeispiel 6

In einem Dreihalskolben ausgerüstet mit Rührer, Rückflußkühler und Tropftrichter werden 50 g des Polymers nach Herstellungsbeispiel 5 in einem Gemisch aus 350 ml n-Propanol und 150 ml Wasser 1 Stunde bei 70 °C gerührt. Dann fügt man 10,5 g konzentrierte Salzsäure zu und tropft unter intensivem Rühren eine Lösung von 22,3 g Butyraldehyd, gelöst in 20 ml n-Propanol, innerhalb von 45 min ein. Die Reaktionsmischung wird noch weitere 3,5 Std. bei 70 °C gerührt und anschließend durch Eintropfen in 3 I Wasser das Produkt ausgefällt. Der abgeschiedene Niederschlag wird abgesaugt, intensiv mit Wasser gewaschen und 2 Tage bei etwa 40 °C getrocknet (Ausbeute: 96 % bezogen auf eingesetztes Polymer nach Herstellungsbeispiel 5, Gehalt an Vinylalkoholeinheiten: 21 Gew.-% und an Vinylacetateinheiten: 6,5 Gew.-%; Säurezahl: 0 mg KOH/g).

### Herstellungsbeispiel 7

Wie im Herstellungsbeispiel 6 beschrieben, wird eine Lösung von 50 g des Polymers nach Herstellungsbeispiel 5 in einer Mischung aus 300 ml n-Propanol und 150 ml Wasser bereitet. Dann fügt man 9 g konzentrierte Salzsäure zu. Anschließend werden bei 60 °C 18,6 g Propionaldehyd innerhalb von 30 min zugetropft und die Mischung noch 3 Stunden gerührt. Nach dem Abkühlen wird das Reaktionsgemisch mit einer Lösung von 9,6 g Natriumcarbonat in 30 ml Wasser neutralisiert und das polymere Bindemittel durch Einrühren in 3 l Wasser ausgefällt. Es wird abgesaugt, mit Wasser intensiv nachgewaschen und 24 Std. bei etwa 40 °C getrocknet (Ausbeute: 94 % bezogen auf eingesetztes Polymer nach Herstellungsbeispiel 5; Gehalt an Vinylalkoholeinheiten: 23,4 Gew.-%; Säurezahl: 0 mg KOH/g).

### Herstellungsbeispiel 8

Es wird wie im Herstellungsbeispiel 6 ausgeführt gearbeitet, jedoch unter Verwendung von 50 g des Polymers aus Herstellungsbeispiel 5, 11.2 g Butyraldehyd, 6,8 g Acetaldehyd und 9 g konzentrierter Salzsäure (30 ml n-Propanol zum Lösen der beiden Aldehyde) (Ausbeute: 93 % bezogen auf eingesetztes Produkt nach Herstellungsbeispiel 5; Vinylalkoholgehalt: 27 Gew.-%; Säurezahl: 0 mg KOH/g).

### Herstellungsbeispiel 9

In einem Dreihalskolben ausgerüstet mit Thermometer, Rückflußkühler, Tropftrichter und magnetischem Rührer werden 50 g Mowilith Ct5 ® in einem Gemisch aus 300 ml n-Propanol, 150 ml Wasser und 8 ml konz. Salzsäure 21 Stunden bei 70 °C gerührt, wobei sich die Lösung eintrübt. Anschließend werden bei der gleichen Temperatur eine Mischung aus 9,8 g Butyraldehyd, 6 g Acetaldehyd und 30 ml n-Propanol innerhalb von 1 Stunde zugetropft und die Mischung noch weitere 4 Stunden gerührt. Dann wird auf Raumtemperatur abgekühlt und eine Lösung von 9,2 g Natriumcarbonat (wasserfrei) in 25 ml Wasser zugegeben, wodurch sich der pH-Wert der Lösung auf 7 einstellt. Anschließend wird das Reaktionsprodukt durch Einrühren der Mischung in 3 l Wasser ausgefällt, wobei intensiv gerührt werden muß. Das Produkt wird abgetrennt, intensiv mit Wasser nachgewaschen und zwei Tage bei etwa 40 °C getrocknet. (Ausbeute: 92 % bezogen auf eingesetztes Mowilith Ct5 ® ; Vinylacetatgehalt: 8 Gew.-%; Säurezahl: 0 mg KOH/g).

### Herstellungsbeispiel 10

Durch Austausch des Lösungsmittelgemisches n-Propanol/Wasser gegen eine Mischung von 400 ml Dimethylsulfoxid und 30 ml Wasser in Herstellungsbeispiel 9 wird ein weiteres Polyvinylacetal hergestellt (Ausbeute: 90 % bezogen auf eingesetztes Mowilith Ct5® ; Gehalt an Vinylalkoholeinheiten: 19,5 Gew.-%; Säurezahl: 0 mg KOH/g)

### Herstellungsbeispiel 11

Es wird wie im Herstellungsbeispiel 9 ausgeführt gearbeitet, jedoch unter Verwendung von 50 g Mowilith Ct5® , 10,8 g Butyraldehyd (25 ml n-Propanol zum Auflösen des Aldehydes) und 7,5 g konzentrierte Salzsäure (Ausbeute: 91 % bezogen auf eingesetztes Mowilith Ct5® ; Gehalt an Vinylalkoholeinheiten: 29 Gew.-%; Säurezahl: 0 mg KOH/g).

### Herstellungsbeispiel 12

Es wird wie im Herstellungsbeispiel 9 ausgeführt gearbeitet, jedoch unter Verwendung von 49 g eines Copolymers, hergestellt durch 6 stündiges Kochen von 118 g Vinylacetat und 9 g Acrylsäure in 500 ml Methylethylketon in Gegenwart von 9,6 g Azo-bis-isobutyronitril, das in Abständen von 2 Stunden zugefügt wurde, und anschließendem Ausfällen in 2 l n-Hexan (Säurezahl des Produktes: 36 mg KOH/g), und 10,8 g Butyraldehyd sowie 6,0 g konz. Salzsäure (Ausbeute bezogen auf eingesetztes Copolymer: 92 %; Säurezahl: 0 mg KOH/g).

### Herstellungsbeispiel 13

20 g des Polymers nach Herstellungsbeispiel 9 werden unter leichtem Erwärmen in 150 ml Methanol gelöst. Anschließend fügt man 10 g einer 40 gew.-%-igen Lösung von Methylamin in Wasser zu, kocht 4 Stunden unter Rückfluß und rührt anschließend die Lösung in 600 ml Wasser ein. Das ausgefallene Produkt wird abgesaugt und 24 Stunden bei 40 °C getrocknet. Die im Polymer enthaltene Säureamidgruppe kann durch eine Bande bei 1640 cm⁻¹ im IR-Spektrum detektiert werden (aufgenommen als Substanzfilm auf Irtran).

### Herstellungsbeispiel 14

Ein Gemisch aus 20 g des Polymers nach Herstellungsbeispiel 10, 3,6 g 1-Aminopropanol-3, 0,4 g 4-Toluolsulfonsäure und 150 ml Ethanol wird 2 Stunden unter Rückfluß gekocht. Dann rührt man die Reaktionslösung in 600 ml Wasser ein, saugt den ausgefallenen Niederschlag ab und trocknet ihn 24 Std. bei 40 °C. Die im Polymer enthaltene Säureamidgruppe kann durch eine Bande bei 1640 cm⁻¹ im IR-Spektrum detektiert werden (aufgenommen als Substanzfilm auf Irtran).

### Herstellungsbeispiel 15

20 g des Polymers nach Herstellungsbeispiel 11 und 2,8 g 4-Aminobenzoesäure werden in 130 ml Ethanol 5 Std. unter Rückfluß gekocht und die Lösung weitere 15 Std. bei Raumtemperatur stehen gelassen. Das Reaktionsprodukt wird durch langsames Einrühren der Lösung in 750 ml Wasser und Absaugen des Niederschlages isoliert. Es wird 24 Stunden bei 40 °C getrocknet (Säurezahl: 25 mg KOH/g; Gehalt an Vinylalkoholeinheiten: 25,4 Gew.-%).

### Herstellungsbeispiel 16

Es wird wie im Herstellungsbeispiel 15 ausgeführt gearbeitet, jedoch unter Verwendung von 20 g des Polymers nach Herstellungsbeispiel 8 und 2,8 g 4-Aminobenzoesäure (Säurezahl: 26 mg KOH/g; Gehalt an Vinylalkoholeinheiten: 22,5 Gew.-%).

### Herstellungsbeispiel 17

Es wird wie im Herstellungsbeispiel 15 ausgeführt gearbeitet, jedoch unter Verwendung von 20 g des Polymers nach Herstellungsbeispiel 10 und 2,8 g 3-Aminobenzoesäure. Die Fällungslösung wird vor dem Absaugen des Produktes 5 Std. bei Raumtemperatur gerührt (Säurezahl: 18,5 mg KOH/g; Gehalt an Vinylalkoholeinheiten: 15,6 Gew.-%).

### Herstellungsbeispiel 18

Es wird wie im Herstellungsbeispiel 15 ausgeführt gearbeitet, jedoch unter Verwendung von 20 g des Polymers nach Herstellungsbeispiel 7 und 2,8 g 4-Aminobenzoesäure (Säurezahl: 24 mg KOH/g; Gehalt an Vinylalkoholeinheiten: 18,5 Gew.-%).

### Herstellungsbeispiel 19

20 g des Polymers aus Herstellungsbeispiel 8, 2.2 g 4-Aminobuttersäure und 0,4 g 4-Toluolsulfonsäure werden in 130 ml eines Gemisches aus 90 Gew.-% Ethanol und 10 Gew.-% Wasser 5 Stunden zum Sieden erhitzt und anschließend weitere 20 Stunden bei Raumtemperatur stehen gelassen. Dann wird das Produkt durch Einrühren in 700 ml Wasser ausgefällt, abgesaugt und 24 Stunden bei 40 °C getrocknet (Säurezahl: 19 mg KOH/g; Gehalt an Vinylalkoholeinheiten: 23 Gew.-%).

### Herstellungsbeispiel 20

Es wird wie im Herstellungsbeispiel 15 ausgeführt gearbeitet, jedoch unter Verwendung von 20 g des Polymers nach Herstellungsbeispiel 12 und 2,7 g 4-Aminobenzoesäure (Säurezahl: 27 mg KOH/g; Gehalt an Vinylalkoholeinheiten: 23,1 Gew.-%).

### Herstellungsbeispiel 21

In einem Dreihalskolben ausgerüstet mit Thermometer, Rückflußkühler, Tropftrichter und magnetischem Rührer werden 50 g Mowilith Ct5® in einem Gemisch aus 300 ml n-Propanol, 150 ml Wasser und 6 ml konz. Salzsäure 21 Stunden bei 70 °C gerührt, wobei sich die Lösung eintrübt. Dann wird die Lösung auf 50 °C abgekühlt, eine Lösung von 15,6 g Propionaldehyd in 30 ml n-Propanol innerhalb von 1 Stunde zugetropft und die Mischung noch weitere 4 Stunden gerührt. Anschließend wird auf Raumtemperatur abgekühlt und solange eine Lösung von 10 g Natriumhydroxid in 50 ml Wasser zugegeben, bis sich der pH-Wert der Lösung auf 3 eingestellt hat. Nach Zufügen von 5,5 g 4-Aminobenzoesäure wird die Lösung nochmals 3 Stunden auf 60 °C erwärmt. Anschließend wird das Reaktionsprodukt durch Einrühren der Mischung in 3 I Wasser ausgefällt, wobei intensiv gerührt werden muß. Das Produkt wird abgetrennt, intensiv mit Wasser nachgewaschen und zwei Tage bei etwa 40 °C getrocknet. (Ausbeute: 92 % bezogen auf eingesetztes Mowilith Ct5® ; Säurezahl: 25 mg KOH/g).

### Herstellungsbeispiel 22

In 225 ml Wasser und 450 ml n-Propanol werden 75 g Mowiol 8/88® (Polyvinylalkohol der Fa. Hoechst mit einem Restacetylgruppengehalt von ca. 21 Gew.-%) bei 70 °C in einem Dreihalskolben mit Kühler, Rührer und Thermometer auf einem Wasserbad gelöst. Die Lösung wird anschließend auf 60 °C abgekühlt und 10,2 ml konzentrierte Salzsäure zugegeben. Dann wird langsam ein Gemisch aus 16,2 g Butyraldehyd und 9,9 g Acetaldehyd zugetropft und 4 Stunden bei 60 °C gerührt. Zur Neutralisation werden 10,6 g Natriumcarbonat, in 50 ml Wasser gelöst, zugesetzt und 30 Minuten gerührt. Anschließend wird das Polymer durch langsames Eingießen in einen Überschuß von Wasser ausgefällt, abfiltriert und in einem Umlufttrockenschrank bei 40 °C 24 Stunden getrocknet. Die analytische Untersuchung des Produktes ergibt 28 Gew.-% Vinylalkoholeinheiten.

### Herstellungsbeispiel 23 basierend auf WO 93/03068

Man rührt eine Mischung aus 25 g Mowiol 5/88® (Polyvinylalkohol der Fa. Hoechst mit einem Restacetylgruppengehalt von ca. 21 Gew.-%), 75 ml Wasser und 150 ml n-Propanol bei 70 °C 20 Stunden lang. Die Lösung wird auf 60 °C abgekühlt. Nach Zugabe von 3,4 g konzentrierter Salzsäure wird im Verlaufe von 2 Stunden erst eine Mischung aus 5,4 g Benzaldehyd, 7,4 g Butyraldehyd und dann 9 g 2-Phthalaldehydsäure (2-Carboxybenzaldehyd) zugegeben. Man läßt 2 Stunden unter Rühren bei 60 °C stehen und gibt soviel Soda dazu, daß ein pH-Wert von 7 erhalten wird. Durch Ausfällen in Wasser, Waschen des Polymers mit Wasser und 24 Stunden Trocknen bei 40°C erhält man ein Produkt mit der Säurezahl 20 mg KOH/g.

### Herstellungsbeispiel 24 basierend auf DE-A-20 533 63

50 g Mowital B60T® (Polyvinylbutyral der Fa. Hoechst mit einem Acetalgehalt von 70 Gew.-%, Vinylalkoholgehalt von 26 Gew.-% und einem Acetatgehalt von 3 Gew.-%) werden in 752 g getrocknetem 1,4-Dioxan bei 40 °C gelöst. Anschließend läßt man bei gleicher Temperatur 27,2 g 4-Toluolsulphonylisocyanat im Verlaufe von 20 Minuten zutropfen. Man läßt weitere 4 Stunden bei 40 °C rühren und fällt das Polymer in einem Überschuß von Wasser aus. Nach gründlichem Waschen mit Wasser wird das Produkt abgesaugt und im Umlufttrockenschrank bei 40 °C 24 Stunden getrocknet.

**Herstellungsbeispiel 25 basierend auf EP-A-0 152 819** 25 g Mowital B60T® (Polyvinylbutyral der Fa. Hoechst mit einem Acetalgehalt von 70 Gew.-%, Vinylalkoholgehalt von 26 Gew.-% und einem Acetatgehalt von 3 Gew.-%) werden in 700 ml Methylethylketon bei 60 °C gelöst und anschließend nach Zugabe von 10 g Maleinsäureanhydrid und 0,7 ml Triethylamin 6 Stunden unter Rückfluß gekocht. Durch Ausfällen in Wasser, Waschen des Polymers mit Wasser und 24 Stunden Trocknen bei 40 °C erhält man ein Produkt mit der Säurezahl 58 mg KOH/g.

### Beispiel 1

Eine Beschichtungslösung wird aus folgenden Komponenten hergestellt:

| | |
|---|---|
| 2,19 g | Bindemittel nach Herstellungsbeispiel 1 |
| 2 g | Polykondensationsprodukt aus 1 Mol 3-Methoxydiphenylamin-4-diazoniumsulfat und 1 Mol 4,4'-Bis-methoxymethyldiphenylether, ausgefällt als Mesitylensulfonat |
| 0,75 g | Renolblau B2G-HW ® (Kupferphthalocyaninpigmentpräparation |
| | mit Polyvinylbutyral der Fa. Hoechst) |
| 0,025 g | 4-Phenylazodiphenylamin |
| 0,035 g | Phosphorsäure |

Die genannten Bestandteile werden unter Rühren in 100 ml eines Gemisches bestehend aus
30 Vol.-Teilen Methylglykol
45 Vol.-Teilen Methanol
25 Vol.-Teilen Methylethylketon
gelöst. Nach Filtrieren der Lösung wird sie auf eine elektrochemisch aufgerauhte und anodisierte Aluminiumfolie, die mit Polyvinylphosphonsäure nachbehandelt worden ist, mit üblichen Verfahren aufgebracht und die Schicht wird 4 min bei 90 °C getrocknet. Das Trockengewicht der Kopierschicht beträgt etwa 1 g/m².

Die Kopierschicht wird unter einem Silberfilm-Halbtonstufenkeil mit einem Dichteumfang von 0,15 bis 1,95, wobei die Dichteinkremente 0,15 betragen, als Negativ-Vorlage mit einer Metallhalogenid-Lampe (MH-Brenner, Fa. W. Sack) mit 300 mJ/cm² belichtet.

Die belichtete Schicht wird mit einer Entwicklerlösung bestehend aus

| | |
|---|---|
| 3,4 | Gew.-Teilen Rewopol NLS 28 ® (30 %ige Lösung von Natriumlaurylsulfat in Wasser der Fa. Rewo) |
| 1,8 | Gew.-Teilen 2-Phenoxyethanol |
| 1,1 | Gew.-Teilen Diethanolamin |
| 1,0 | Gew.-Teil Texapon 842 ® (42 %ige Lösung von Octylsulfat in Wasser der Fa. Henkel) |
| 0,6 | Gew.-Teilen Nekal BX Paste® (Natriumsalz einer Alkylnaphthalinsulfonsäure der Fa. BASF) |
| 0,2 | Gew.-Teilen 4-Toluolsulfonsäure |
| 91,9 | Gew.-Teilen Wasser |

30 s behandelt. Anschließend wird die Entwicklerlösung nochmals 30 s mit einem Tampon auf der Oberfläche verrieben und dann die gesamte Platte mit Wasser abgespült. Nach dieser Behandlung verbleiben die belichteten Teile auf der Platte. Zur Bewertung der Lichtempfindlichkeit und der Farbannahme wird die Platte im nassen Zustand mit einer Druckfarbe eingeschwärzt. Als Druckfarbe wurden die Produkte PC 904 ® (Fa. Polychrome) und RC 43 ® (Fa. Hoechst) verwendet.

Die Farbannahme der Platte ist mit beiden Druckfarben gut und aufbelichtete Mikrolinien werden sehr gut reproduziert. Der Graukeil ist bis zu Stufe 5 vollständig und bis zu Stufe 9 teilweise gedeckt.

Um die Entwickelbarkeit der nicht belichteten Schicht zu prüfen und sie mit anderen Formulierungen vergleichen zu können, wird wie folgt verfahren: in zeitlichen Abständen von 5 s wird die beschichtete Aluminiumfolie mit Hilfe einer Pipette streifenweise mit obiger Entwicklerlösung beladen. Nach einer Einwirkzeit des Entwicklers auf dem ersten Streifen von 30 s wird die gesamte Folie unter einer Wasserbrause schnell und gleichmäßig abgespült. Eine Hälfte der Folie wird anschließend mit Druckfarbe eingeschwärzt und dann die Folie getrocknet. Es wird die Zeit (im folgenden als Droptest bezeichnet) der Entwicklereinwirkung ermittelt, nach der die Schicht auf der nicht eingeschwärzten Hälfte vollständig von der Folie entfernt bzw. nach der auf der eingeschwärzten Hälfte keine Farbannahme festzustellen ist. Diese beträgt in beiden Fällen 10 s.

Zur Bereitung einer Druckplatte wird, wie oben angegeben, eine Kopierschicht auf die Aluminiumfolie aufgebracht, belichtet, entwickelt und die entwickelte Platte nach dem Spülen mit Wasser abgerakelt und mit einer wäßrigen Lösung von 0,5 %iger Phosphorsäure und 6 %igem Gummi arabicum abgerieben. Die so hergestellte Platte wird in eine Bogenoffset-Druckmaschine eingespannt und liefert unter normalen Druckbedingungen 180.000 Kopien in guter Qualität. Die Platte könnte weiter zum Drucken verwendet werden.

### Beispiel 2

Beispiel 1 wird wiederholt, jedoch wird statt des Polymers nach Herstellungsbeispiel 1 das von Herstellungsbeispiel 2 eingesetzt und verarbeitet. Die entstandene Kopierschicht liefert im eingeschwärzten Zustand eine Feststufe von 5 und eine noch gedeckte Stufe 8. Farbannahmeprobleme treten nicht auf. Der Droptest beträgt für beide Fälle 10 s. Eine Druckplatte, eingespannt in eine Bogenoffsetdruckmaschine, zeigte nach einer Auflage von 150.000 Kopien kaum Verschleißerscheinungen.

### Beispiel 3

Beispiel 1 wird wiederholt, jedoch wird statt des Polymers nach Herstellungsbeispiel 1 das von Herstellungsbeispiel 3 eingesetzt und verarbeitet. Die entstandene Kopierschicht liefert im eingeschwärzten Zustand eine Feststufe von 5 und eine noch gedeckte Stufe 7. Farbannahmeprobleme treten nicht auf. Der Droptest beträgt für beide Fälle 10 s. Eine Druckplatte, eingespannt in eine Bogenoffsetdruckmaschine, zeigte nach einer Auflage von 150.000 Kopien kaum Verschleißerscheinungen.

### Beispiel 4

Beispiel 1 wird wiederholt, jedoch wird statt des Polymers nach Herstellungsbeispiel 1 das von Herstellungsbeispiel 4 eingesetzt und verarbeitet. Die entstandene Kopierschicht liefert im eingeschwärzten Zustand eine Feststufe von 3 und eine noch gedeckte Stufe 7. Farbannahmeprobleme treten nicht auf. Der Droptest beträgt für beide Fälle 10 s. Eine Druckplatte, eingespannt in eine Bogenoffsetdruckmaschine, zeigte nach einer Auflage von 150.000 Kopien kaum Verschleißerscheinungen.

### Beispiel 5

Eine Beschichtungslösung wird aus folgenden Komponenten hergestellt:

| | |
|---|---|
| 3,2 g | Polymer nach Herstellungsbeispiel 15 |
| 2,5 g | eines Polykondensationsproduktes aus 1 Mol 3-Methoxydiphenylamin-4-diazoniumsulfat und 1 Mol 4,4'-Bismethoxymethyldiphenylether, ausgefällt als Mesitylensulfonat |
| 0,75 g | Renolblau B2G HW® (Kupferphthalocyaninpigmentpräparation mit Polyvinylbutyral der Fa. Hoechst) |
| 0,1 g | 4-Phenylazodiphenylamin |
| 0,1 g | Phosphorsäure (85 %ig). |

Die genannten Bestandteile werden wie in Beispiel 1 angegeben gelöst, zu einer Druckplatte verarbeitet und getestet. Die entstandene Kopierschicht liefert im eingeschwärzten Zustand eine Feststufe von 3 und eine noch gedeckte Stufe 9. Farbannahmeprobleme treten nicht auf. Der Droptest beträgt für beide Fälle 10 s. Eine Druckplatte, eingespannt in eine Bogenoffsetdruckmaschine, zeigte nach einer Auflage von 180.000 Kopien kaum Verschleißerscheinungen.

### Beispiel 6

Beispiel 5 wird wiederholt, jedoch wird statt des Polymers nach Herstellungsbeispiel 15 das von Herstellungsbeispiel 17 eingesetzt und verarbeitet. Die entstandene Kopierschicht liefert im eingeschwärzten Zustand eine Feststufe von 3 und eine noch gedeckte Stufe 9. Farbannahmeprobleme treten nicht auf. Der Droptest beträgt für beide Fälle 15 s. Eine Druckplatte, eingespannt in eine Bogenoffsetdruckmaschine, zeigte nach einer Auflage von 140.000 Kopien kaum Verschleißerscheinungen.

### Beispiel 7

Der Versuch von Beispiel 5 wird wie folgt abgewandelt: Anstelle des Polymers aus Herstellungsbeispiel 15 wird das nach Herstellungsbeispiel 12 verwendet. Die gewichtsmäßige Zusammensetzung der Beschichtungslösung und ihre Weiterverarbeitung werden nicht geändert.

Die erfindungsgemäßen Kopierschichten zeigen nach dem Einschwärzen eine Feststufe von 2 und eine gedeckte Stufe von 8. Das Einschwärzen geschieht mit beiden Farben gleichmäßig. Der Droptest ist 15 s für beide Fälle. Eine Druckplatte ergab in der Bogenoffsetdruckmaschine eine Auflage von 130.000 Kopien. Sie könnte weiter zum Drucken verwendet werden.

### Beispiel 8

Eine Beschichtungslösung wird aus folgenden Komponenten:

| | |
|---|---|
| 4,3 g | Polymer nach Herstellungsbeispiel 16 |
| 1,8 g | eines Polykondensationsproduktes aus 1 Mol 3-Methoxydiphenylamin-4-diazoniumsulfat und 1,2 Mol Formaldehyd, ausgefällt als Hexafluorophosphat |
| 0,2 g | Viktoriareinblau BO |
| 0,1 g | Phosphorsäure (85 %ig) |

und dem Lösungsmittelgemisch aus Beispiel 1 hergestellt und wie dort angegeben weiter verarbeitet.

Das Trockengewicht der Kopierschicht beträgt etwa 1,1 g/m². Die Farbannahme der Platte ist gut und aufbelichtete Mikrolinien werden sehr gut reproduziert. Der Graukeil ist bis zur Stufe 4 vollständig und die Stufen bis 10 teilweise gedeckt. Der Droptest ist 5 s für beide Fälle. Die Druckplatten liefern 100.000 Kopien in guter Qualität. Die Platte könnte weiter zum Drucken verwendet werden.

### Beispiel 9

Eine Beschichtungslösung wird aus folgenden Komponenten

| | |
|---|---|
| 4,1 g | Polymer nach Herstellungsbeispiel 14 |
| 1,1 g | eines Polykondensationsproduktes aus 1 Mol 3-Methoxydiphenyl-4-diazoniumsulfat und 1 Mol 4,4'-Bis-methoxymethyldiphenylether, ausgefällt als 4-Tolylsulfonat |
| 0,2 g | OB 613 ® (Orient Chemical Industry Co.) |
| 0,1 g | Phosphorsäure (85 %ig) |

und dem Lösungsmittelgemisch aus Beispiel 1 hergestellt und wie dort angegeben weiter verarbeitet.

Die erfindungsgemäßen Kopierschichten mit dieser Formulierung haben einen Droptest von 10 s für beide Fälle, im eingeschwärzten Zustand eine Feststufe von 2 und gedeckte Stufen bis 9. Die fertige Druckplatte wird in eine Bogenoffsetdruckmaschine eingespannt und liefert unter normalen Druckbedingungen 140.000 Kopien in guter Qualität ohne wesentliche Verschleißerscheinungen.

### Beispiel 10

Eine Beschichtungslösung wird aus folgenden Komponenten hergestellt:

| | |
|---|---|
| 5,2 g | Polymer nach Herstellungsbeispiel 18 |
| 2,8 g | einer 80%igen Lösung eines Urethanacrylates in Methylethylketon hergestellt durch Reaktion von 1-Methyl-2,4-bisisocyanatobenzol (Desmodur N100 ® der Fa. Bayer) mit Hydroxyethylacrylat und Pentaerythritoltriacrylat mit einem Doppelbindungsgehalt von 0,50 Doppelbindungen/100 g bei vollständigem Umsatz der Isocyanatgruppe |
| 1,4 g | Dipentaerythritolpentaacrylat |
| 0,17 g | 2-(4-Methoxynaphthyl-1-yl)-4,6-bis-(trichlormethyl)-s-triazin |
| 0,3 g | Polykondensationsprodukt aus 1 Mol 3-Methoxy-diphenylamin-4-diazoniumsulfat und 1 Mol 4,4'-Bis-methoxymethyldiphenylether, ausgefällt als Mesitylensulfonat |
| 0,2 g | Viktoriareinblau BO |
| 0,1 g | Phosphorsäure (85%ig) |

Die genannten Bestandteile werden unter Rühren in 100 ml eines Gemisches bestehend aus
30 Vol.-Teilen Methylglykol
45 Vol.-Teilen Methanol
25 Vol.-Teilen Methylethylketon
gelöst. Nach Filtrieren der Lösung wird sie auf eine elektrochemisch aufgerauhte und anodisierte Aluminumfolie, die mit einer wäßrigen Lösung von Polyvinylphosphonsäure nachbehandelt worden ist, mit üblichen Verfahren aufgebracht und die Schicht wird 4 min bei 90 °C getrocknet. Das Trockengewicht der Kopierschicht beträgt etwa 1 g/m².

Anschließend wird in analoger Weise eine Sauerstoffsperrschicht von 0,4 g/m² Trockenschichtgewicht durch Beschichten mit einer Lösung folgender Zusammensetzung aufgebracht:

| | |
|---|---|
| 50 g | Polyvinylalkohol (Airvol 203 ® der Fa. Air Products; 12 Gew.-% Restacetylgruppen) |
| 170g | Wasser |

Die Trocknung erfolgt 5 min bei 95 °C.

Die Platte wird in der im Beipiel 1 beschriebenen Weise belichtet, entwickelt, eingeschwärzt und gedruckt. Der Droptest der Kopierschicht ist für beide Fälle 10 s. Die Farbannahme der Platte ist gut und aufbelichtete Mikrolinien werden sehr gut reproduziert. Die zweite Stufe des Graukeils ist vollständig und die Stufen bis 10 teilweise gedeckt.

Die so hergestellte Platte wird in eine Bogenoffsetdruckmaschine eingespannt und liefert unter normalen Druckbedingungen 100.000 Kopien in guter Qualität. Die Platte könnte weiter zum Drucken verwendet werden.

### Beispiel 11

Eine Beschichtungslösung wird aus folgenden Komponenten hergestellt:

| | |
|---|---|
| 3,3 g | Polymer nach Herstellungsbeispiel 19 |
| 4,7 g | einer 80%igen Lösung eines Urethanacrylates hergestellt durch Reaktion von 1-Methyl-2,4-bisisocyanatobenzol (Desmodur N100 ® der Fa. Bayer) mit Hydroxyethylacrylat und Pentaerythritoltriacrylat mit einem Doppelbindungsgehalt von |
| | 0,5 Doppelbindungen/100 g bei vollständigem Umsatz der Isocyanatgruppen |
| 0,17 g | 2-(4-Methoxynaphth-1-yl)-4,6-bis-(trichlormethyl)-1,3,5-triazin |
| 0,16 g | 4,4'-N,N-Diethylaminobenzophenon |
| 0,19 g | 3-Mercapto-1,2,4-triazol |
| 0,12 g | Kongorot |
| 0,2 g | Leukokristallviolett |

Die genannten Bestandteile werden unter Rühren in 100 ml eines Gemisches bestehend aus
35 Vol.-Teilen Methylglykol
25 Vol.-Teilen Methanol
40 Vol.-Teilen Methylethylketon
gelöst. Nach Filtrieren der Lösung wird sie auf eine elektrochemisch aufgerauhte und anodisierte Aluminiumfolie, die mit einer wäßrigen Lösung von Polyvinylphosphonsäure nachbehandelt worden ist, mit üblichen Verfahren aufgebracht und die Schicht wird 4 min bei 90 °C getrocknet. Das Gewicht der Kopierschicht beträgt etwa 2,0 g/m².

Anschließend wird in analoger Weise eine Sauerstoffsperrschicht von 1,8 g/m² Trockengewicht durch Beschichten mit einer Lösung folgender Zusammensetzung aufgebracht:

| | |
|---|---|
| 50 g | Polyvinylalkohol (Airvol 203 ® der Fa. Airproducts; 12 Gew.-% Restacetylgruppengehalt) |
| 270 g | Wasser |

Die Trocknung erfolgt 5 min bei 90 °C.

Die Platte wird in der im Beispiel 1 beschriebenen Weise, aber mit einer Lichtmenge von 20 mJ/cm², belichtet. Unmittelbar im Anschluß an die Belichtung wird die Platte 1 min auf 95 °C zur Verstärkung der ablaufenden Photopolymerisation erwärmt. Die Entwicklung und Einschwärzung erfolgt in der in Beispiel 1 beschriebenen Weise.

Der Droptest der Kopierschicht ist 10 s für beide Fälle. Die Farbannahme der Platte ist gut. Die erste Stufe des Graukeils ist vollständig und die Stufen bis 6 teilweise gedeckt.

Die so hergestellte Platte wird in eine Bogenoffsetdruckmaschine eingespannt und liefert unter normalen Druckbedingungen 100.000 Kopien in guter Qualität. Die Platte könnte weiter zum Drucken verwendet werden.

### Vergleichsbeispiel 1

Eine Beschichtungslösung wird aus folgenden Komponenten hergestellt:

| | |
|---|---|
| 3,2 g | Polymer nach Herstellungsbeispiel 11 |
| 2,5 g | Polykondensationsprodukt aus 1 Mol 3-Methoxydiphenylamin-4-diazoniumsulfat und 1 Mol 4,4'-Bis-methoxymethyldiphenylether, ausgefällt als Mesitylensulfonat |
| 0,75 g | Renolblau B2G HW® (Kupferphthalocyaninpigmentpräparation mit Polyvinylbutyral der Fa. Hoechst) |
| 0,1 g | 4-Phenylazodiphenylamin |
| 0,1 g | Phosphorsäure (85 %ig). |

Die genannten Bestandteile werden unter Rühren in 100 ml eines Gemisches bestehend aus
45 Vol.-Teilen Methanol
30 Vol.-Teilen Methylglykol
25 Vol.-Teilen Methylethylketon
gelöst. Nach Filtrieren der Lösung wird sie auf eine elektrochemisch aufgerauhte und anodisierte Aluminiumfolie, die mit Polyvinylphosphonsäure nachbehandelt worden ist, mit üblichen Verfahren aufgebracht und die Schicht wird 4 min bei 90 °C getrocknet. Das Trockengewicht der Kopierschicht beträgt etwa 1 g/m².

Der Droptest der Schicht ist 30 s für den nichteingeschwärzten Teil und 25 s für den eingeschwärzten Teil.

Die Platte wird wie in der in Beispiel 1 beschriebenen Weise belichtet, entwickelt, eingeschwärzt und gedruckt.

Die Farbannahme ist gut und aufbelichtete. Mikrolinien werden gut reproduziert. Der Graukeil ist bis zu Stufe 2 vollständig gededet und bis zu Stufe 8 teilweise gedeckt. Bei 120.000 Kopien sind deutliche Verschleißerscheinungen in den Vollflächen sowie Rasterpunkten erkennbar.

Die Ergebnisse zeigen, daß durch die erfindungsgemäße Einführung von Säureamidgruppierungen gemäß Herstellungsbeispiel 15 und erfindungsgemäße Anwendung gemäß Beispiel 5 eine signifikante Verbesserung der anwendungstechnischen Eigenschaften eintritt.

### Vergleichsbeispiel 2

Eine Beschichtungslösung wird aus folgenden Komponenten hergestellt:

| | |
|---|---|
| 4,38 g | Polyvinylbutyral mit einem mittleren Molekulargewicht von 30.000, das 70 Gew.-% Butyraleinheiten, 27 Gew.-% Vinylalkoholeinheiten und 3 Gew.-% Vinylacetateinheiten enthält |
| 4 g | Polykondensationsprodukt aus 1 Mol 3-Methoxy-diphenylamin-4-diazoniumsulfat und 1 Mol 4,4'-Bis-methoxymethyldiphenylether, ausgefällt als Mesitylensulfonat |
| 1,5 g | Renolblau B2G HW ® (Kupferphthalocyaninpigmentpräparation mit Polyvinylbutyral der Fa. Hoechst) |
| 0,05 g | 4-Phenylazodiphenylamin |
| 0,07 g | Phosphorsäure |

Die genannten Bestandteile werden unter Rühren in 200 ml eines Gemisches bestehend aus
30 Vol.-Teilen Methylglykol
45 Vol.-Teilen Methanol
25 Vol.-Teilen Methylethylketon
gelöst. Nach Filtrieren der Lösung wird sie auf eine elektrochemisch aufgerauhte und anodisierte Aluminiumfolie, die mit einer wäßrigen Lösung von Polyvinylphosphonsäure nachbehandelt worden ist, mit üblichen Verfahren aufgebracht und die Schicht wird 4 min bei 90°C getrocknet. Das Trockengewicht der Kopierschicht beträgt etwa 1g/m².

Die Platte wird in der im Beispiel 1 beschriebenen Weise belichtet, entwickelt und eingeschwärzt.

Die so hergestellten Platten erweisen sich als sehr schwer entwickelbar. Nur mittels starker mechanischer Unterstützung gelingt es unbelichtete Bereiche von anhaftenden Schichtresten zu befreien. Die unbelichteten Schichtteile sind z.T. im Entwickler unlöslich und neigen zu Ablagerungen auf der Platte und in den zur Entwicklung verwendeten Maschinen. Das Auflösungsvermögen ist schlecht, da die Zwischenräume zwischen feinen Details nicht sauber entwickelt werden.

### Vergleichsbeispiel 3

Eine Beschichtungslösung wird aus folgenden Komponenten hergestellt:

| | |
|---|---|
| 4,38 g | Bindemittel nach Herstellungsbeispiel 22 |
| 4 g | Polykondensationsprodukt aus 1 Mol 3-Methoxy-diphenylamin-4-diazoniumsulfat und 1 Mol 4,4'-Bismethoxymethyldiphenylether, ausgefällt als Mesitylensulfonat |
| 1,5 g | Renolblau B2G HW® (Kupferphthalocyaninpigmentpräparation mit Polyvinylbutyral der Fa. Hoechst) |
| 0,05 g | 4-Phenylazodiphenylamin |
| 0,07 g | Phosphorsäure |

Die genannten Bestandteile werden unter Rühren in 200 ml eines Gemisches bestehend aus
30 Vol.-Teilen Methylglykol
45 Vol.-Teilen Methanol
25 Vol.-Teilen Methylethylketon
gelöst. Nach Filtrieren der Lösung wird sie auf eine elektrochemisch aufgerauhte und anodisierte Aluminiumfolie, die mit einer wäßrigen Lösung von Polyvinylphosphonsäure nachbehandelt worden ist, mit üblichen Verfahren aufgebracht und die Schicht wird 4 min bei 90°C getrocknet. Das Trockengewicht der Kopierschicht beträgt etwa 1g/m².

Die Platte wird in der im Beispiel 1 beschriebenen Weise belichtet, entwickelt und eingeschwärzt.

Die Reproduktion von feinen Rasterpunkten ist ausreichend. Die erste Stufe des Graukeils ist vollständig und die Stufen bis 7 teilweise gedeckt.

Die Empfindlichkeit ist jedoch deutlich niedriger als bei Verwendung von erfindungsgemäß hergestellten Polymeren.

Zur Simulation einer Alterung der Platten, werden diese bei einer Temperatur von 40 °C und 80 % relativer Luftfeuchte 10 Tage gelagert. Die so behandelten Platten werden in eine Bogenoffset-Maschine zum Drucken verwendet. Unter normalen Druckbedingungen zeigen sie bereits nach 50.000 Kopien starken Verschleiß der Vollflächen.

### Vergleichsbeispiel 4

Eine Beschichtungslösung wird aus folgenden Komponenten hergestellt:

| | |
|---|---|
| 5,43 g | Bindemittel nach Herstellungsbeispiel 23 |
| 4 g | Polykondensationsprodukt aus 1 Mol 3-Methoxydiphenylamin-4-diazoniumsulfat und 1 Mol 4,4'-Bis-methoxymethyldiphenylether, ausgefällt als Mesitylensulfonat |
| 0,5 g | Viktoria Reinblau (C.I. Solvent Blue 5) |
| 0,07 g | Phosphorsäure |

Die genannten Bestandteile werden unter Rühren in 200 ml eines Gemisches bestehend aus
30 Vol.-Teilen Methylglykol
45 Vol.-Teilen Methanol
25 Vol.-Teilen Methylethylketon
gelöst. Nach Filtrieren der Lösung wird sie auf eine elektrochemisch aufgerauhte und anodisierte Aluminiumfolie, die mit einer wäßrigen Lösung von Polyvinylphosphonsäure nachbehandelt worden ist, mit üblichen Verfahren aufgebracht und die Schicht wird 4 min bei 90°C getrocknet. Das Trockengewicht der Kopierschicht beträgt etwa 1g/m².

Die Platte wird in der im Beispiel 1 beschriebenen Weise belichtet, entwickelt und eingeschwärzt.

Die ersten 2 Stufen des Graukeils sind vollständig und die Stufen bis 7 teilweise gedeckt. Die Empfindlichkeit ist jedoch deutlich niediger als bei Verwendung von erfindungsgemäß hergestellten Polymeren.

Weiterhin benötigt die Platte wenigstens 15 Sekunden Entwicklungszeit im Gegensatz zu 5 Sekunden bei erfindungsgemäß hergestellten Druckformen. Das führt bei schnellen Entwicklungsmaschinen und Entwicklern nahe der Erschöpfung zu nicht sauber entwickelten Platten.

### Vergleichsbeispiel 5

Eine Beschichtungslösung wird aus folgenden Komponenten hergestellt:

| | |
|---|---|
| 6,38 g | Polymer entsprechend Herstellungsbeispiel 24 |
| 2 g | Polykondensationsprodukt aus 1 Mol 3-Methoxy-diphenylamin-4-diazoniumsulfat und 1 Mol 4,4'-Bis-methoxymethyldiphenylether, ausgefällt als Mesitylensulfonat |
| 1,5 g | Renolblau B2G-HW ® (Kupferphthalocyaninpigmentpräparation mit Polyvinylbutyral der Fa. Hoechst) |
| 0,05 g | 4-Phenylazodiphenylamin |
| 0,07 g | Phosphorsäure |

Die genannten Bestandteile werden unter Rühren in 200 ml eines Gemisches bestehend aus
- 30: Vol.-Teilen Methylglykol
- 45: Vol.-Teilen Methanol
- 25: Vol.-Teilen Methylethylketon
gelöst. Nach Filtrieren der Lösung wird sie auf eine elektrochemisch aufgerauhte und anodisierte Aluminiumfolie, die mit einer wäßrigen Lösung von Polyvinylphosphonsäure nachbehandelt worden ist, mit üblichen Verfahren aufgebracht und die Schicht wird 4 min bei 90°C getrocknet. Das Trockengewicht der Kopierschicht beträgt etwa 1g/m².

Die Platte wird in der im Beispiel 1 beschriebenen Weise belichtet, entwickelt und eingeschwärzt.

Die Farbannahme der Platte ist schlechter als bei erfindungsgemäß hergestellten Druckplatten. Die ersten 2 Stufen des Graukeils sind vollständig und die Stufen bis 8 teilweise gedeckt.

Die so hergestellte Platte wird in eine Bogenoffset-Maschine eingespannt und zeigte unter normalen Druckbedingungen nach 100.000 Kopien starke Verluste an Mikroelementen, und beginnende Verschleißerscheinungen in den Vollflächen.

### Vergleichsbeispiel 6

Eine Beschichtungslösung wird aus folgenden Komponenten hergestellt:

| | |
|---|---|
| 5,85 g | Polymer gemäß Herstellungsbeipiel 25 (nach EP 0 152 819) |
| 3 g | Polykondensationsprodukt aus 1 Mol 3-Methoxy-diphenylamin-4-diazoniumsulfat und 1 Mol 4,4'-Bis-methoxymethyldiphenylether, ausgefällt als Mesitylensulfonat |
| 1 g | Renolblau B2G HW ® (Kupferphthalocyaninpigmentpräparation mit Polyvinylbutyral der Fa. Hoechst) |
| 0,05 g | 4-Phenylazodiphenylamin |
| 0,1 g | Phosphorsäure |

Die genannten Bestandteile werden unter Rühren in 200 ml eines Gemisches bestehend aus
30 Vol.-Teilen Methylglykol
45 Vol.-Teilen Methanol
25 Vol.-Teilen Methylethylketon
gelöst. Nach Filtrieren der Lösung wird sie auf eine elektrochemisch aufgerauhte und anodisierte Aluminiumfolie, die mit einer wäßrigen Lösung von Polyvinylphosphonsäure nachbehandelt worden ist, mit üblichen Verfahren aufgebracht und die Schicht wird 4 min bei 90°C getrocknet. Das Trockengewicht der Kopierschicht beträgt etwa 1g/m².

Die Platte wird in der im Beispiel 1 beschriebenen Weise belichtet, entwickelt, eingeschwärzt und gedruckt.

Die Reproduktion von feinen Rasterpunkten ist ausreichend. Die erste Stufe des Graukeils ist vollständig und die Stufen bis 7 teilweise gedeckt.

Die Empfindlichkeit ist jedoch deutlich niedriger als bei Verwendung von erfindungsgemäß hergestellten Polymeren.

### Vergleichsbeispiel 7

Eine Beschichtungslösung wird aus folgenden Komponenten hergestellt:

| | |
|---|---|
| 5,45 g | Scripset 540 ® (Butylhalbester des Maleinsäureanhydrid/Styrol Copolymeren der Fa. Monsanto) |
| 4 g | Polykondensationsprodukt aus 1 Mol 3-Methoxydiphenylamin-4-diazoniumsulfat und 1 Mol 4,4'-Bis-methoxymethyldiphenyl-ether, ausgefällt als Mesitylensulfonat |
| 0,5 g | Viktoria Reinblau (C.I. Solvent Blue 5) |
| 0,05 g | Phosphorsäure |

Die genannten Bestandteile werden unter Rühren in 100ml eines Gemisches bestehend aus
30 Vol.-Teilen Methylglykol
45 Vol.-Teilen Methanol
25 Vol.-Teilen Methylethylketon
gelöst. Nach Filtrieren der Lösung wird sie auf eine elektrochemisch aufgerauhte und anodisierte Aluminiumfolie, die mit einer wäßrigen Lösung von Polyvinylphosphonsäure nachbehandelt worden ist, mit üblichen Verfahren aufgebracht und die Schicht wird 4 min bei 90 °C getrocknet. Das Trockengewicht der Kopierschicht beträgt etwa 1g/m².

Die Platte wird in der im Beispiel 1 beschriebenen Weise belichtet, entwickelt, eingeschwärzt und gedruckt.

Die Farbannahme beim manuellen Einschwärzen der Platte ist unzureichend und aufbelichtete Mikrolinien werden schlecht reproduziert. Die erste Stufe des Graukeils ist vollständig und die Stufen bis 7 teilweise gedeckt.

Die so hergestellte Platte wird in eine Bogenoffset-Maschine eingespannt. Beim Druck nimmt die Platte schlecht Farbe an, wobei insbesondere die Farbannahme der Vollflächen fleckig ist. Nach 100.000 Kopien sind deutliche Verschleißerscheinungen in den Vollflächen sowie Rasterpunkten erkennbar.

Die Ergebnisse zeigen, daß Druckplatten mit erfindungsgemäß hergestellten Bindemitteln signifikant bessere Annahme der Druckfarbe und Auflagenbeständigkeit aufweisen.

### Vergleichsbeispiel 8

Eine Beschichtungslösung wird aus folgenden Komponenten hergestellt:

| | |
|---|---|
| 5,45 g | CAP ® (Celluose-Acetat/Phthalat der Fa. Eastman Kodak) |
| 4 g | Polykondensationsprodukt aus 1 Mol 3-Methoxy-diphenylamin-4-diazoniumsulfat und 1 Mol 4,4'-Bis-methoxymethyldiphenylether, ausgefällt als Mesitylensulfonat |
| 0,5 g | Viktoria Reinblau (C.I. Solvent Blue 5) |
| 0,05 g | Phosphorsäure (85 %ig) |

Die genannten Bestandteile werden unter Rühren in 100 ml eines Gemisches bestehend aus
30 Vol.-Teilen Methylglykol
45 Vol.-Teilen Methanol
25 Vol.-Teilen Methylethylketon
gelöst. Nach Filtrieren der Lösung wird sie auf eine elektrochemisch aufgerauhte und anodisierte Aluminiumfolie, die mit einer wäßrigen Lösung von Polyvinylphosphonsäure nachbehandelt worden ist, mit üblichen Verfahren aufgebracht und die Schicht wird 4 min bei 90°C getrocknet. Das Trockengewicht der Kopierschicht beträgt etwa 1g/m².

Die Platte wird in der im Beispiel 1 beschriebenen Weise belichtet, entwickelt, eingeschwärzt und gedruckt.

Die Farbannahme beim manuellen Einschwärzen der Platte und die Empfindlichkeit sind unzureichend (erste Stufe des Graukeils ist vollständig und die Stufen bis 5 teilweise gedeckt).

Die so hergestellte Platte wird in eine Bogenoffset-Maschine eingespannt. Beim Druck nimmt die Platte schlecht Farbe an und die Farbannahme der Vollflächen ist fleckig. Nach 60.000 Kopien sind deutliche Verschleißerscheinungen in den Vollflächen sowie Rasterpunkten erkennbar.

Die Ergebnisse zeigen, daß Druckplatten mit erfindungsgemäß hergestellten Bindemitteln eine signifikant bessere Annahme der Druckfarbe, eine höhere Lichtempfindlichkeit sowie eine höhere Auflagenbeständigkeit aufweisen.

## Patentansprüche

1. Bindemittel, enthaltend die Einheiten A, B, C und D, wobei A in einem Mengenanteil von 0.1 bis 25 Gew.-% vorliegt und der Formel 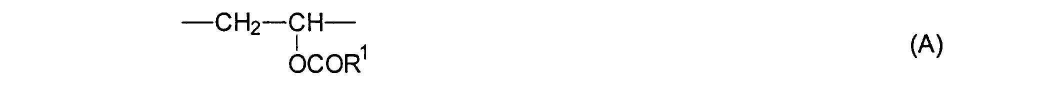 entspricht, in der R¹ ein Wasserstoffatom oder ein aliphatischer Kohlenwasserstoffrest mit 1 bis 4 Kohlenstoffatomen oder ein aromatischer Rest ist, B in einem Mengenanteil von 10 bis 50 Gew.-% vorliegt und der Formel 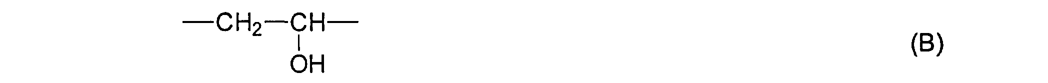 entspricht, C in einem Mengenanteil von 10 bis 80 Gew.-% vorliegt und der Formel 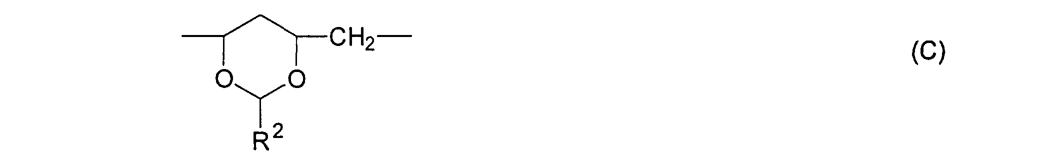 entspricht, in der R² ein Wasserstoffatom, ein Alkyl-, Aralkyl- oder Arylrest ist, und diese Einheit mit verschiedenen Resten R² unabhängig voneinander mehrmals enthalten sein kann, und D in einem Mengenanteil von 1 bis 40 Gew.-% vorliegt und der Formel 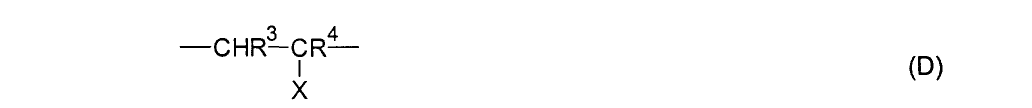 entspricht, in der X entweder die Gruppierung -NHCO-R⁵ oder -CO-NHR⁶ darstellt und R³ und R⁴ Wasserstoffatome oder Alkylreste mit Kohlenstoffzahlen zwischen 1 und 10 sind, R⁵ ein Wasserstoffatom oder ein aliphatischer gesättigter oder ungesättigter Kohlenwasserstoffrest mit 1 bis 10 Kohlenstoffatomen, der mit einer Carboxylgruppe substituiert sein kann, oder ein aromatischer Kohlenwasserstoffrest, der mit einer Carboxylgruppe und weiteren Substituenten substituiert sein kann, ist und R⁶ ein Kohlenwasserstoffrest mit 1 bis 6 Kohlenstoffatomen, der durch eine oder mehrere Hydroxyl-, Ether- oder Amino-, Monoalkylamino-, Dialkylamino- oder Carboxylgruppen substituiert sein kann, wobei die Alkylreste der substituierten Aminogruppe oder der Ethergruppe 1 bis 3 Kohlenstoffatome enthalten, oder ein aromatischer Kohlenwasserstoffrest, der mindestens eine Carboxyl- oder Sulfonsäuregruppe, aber auch weitere Substituenten enthält, ist und diese Einheit jeweils mit verschiedenen Resten R⁵ oder R⁶ unabhängig voneinander mehrmals enthalten sein kann.

2. Lichtempfindliche Zusammensetzung, enthaltend:
(i) ein Diazoniumpolykondensationsprodukt oder
ein radikalisch polymerisierbares System bestehend aus Photoinitiatoren und ungesättigten Verbindungen, die radikalisch polymerisierbar sind oder
ein Hybridsystem bestehend aus einem Diazoniumpolykondensationsprodukt und einem radikalisch polymerisierbaren System bestehend aus Photoinitiatoren und ungesättigten Verbindungen, die radikalisch polymerisierbar sind, und
(ii) ein Bindemittel gemäß Anspruch 1.

3. Zusammensetzung nach Anspruch 2, in der als lichtempfindliche Komponente ein Polykonsationsprodukt aus 3-Methoxydiphenylamin-4-diazoniumsulfat und 4,4'-Bis-methoxymethyldiphenylether, das aus wäßriger Lösung als organisches Sulfonat,Tetrafluoroborat, Hexafluorophosphat, Hexafluoroantimonat oder Hexafluoroarsenat ausgefällt wurde, enthalten ist.

4. Zusammensetzung nach Anspruch 2, in der als lichtempfindliche Komponente ein radikalbildender Photoinitiator oder Mischungen aus Photoinitiatoren und Coinitiatoren, die die Zusammensetzung für den Wellenlängenbereich von 300 bis 800 nm sensibilisieren, sowie radikalisch polymerisierbare Bestandteile mit ungesättigten Gruppen enthalten sind.

5. Zusammensetzung nach Anspruch 2, in der als lichtempfindliche Komponenten ein Diazopolykondensationsprodukt gemäß Anspruch 3 in Kombination mit einem radikalischen Photoinitiatorsystem sowie radikalisch polymerisierbaren Bestandteilen gemäß Anspruch 4 enthalten sind.

6. Zusammensetzung nach einem der Ansprüche 2 bis 5, in der zusätzlich ein oder mehrere Belichtungsindikatoren, ein oder mehrere Farbstoffe zur Erhöhung des Bildkontrastes sowie eine oder mehrere Säuren zur Stabilisierung der lichtempfindlichen Zusammensetzung enthalten sind.

7. Verwendung einer Zusammensetzung nach Anspruch 6 zur Herstellung von Druckplatten.

8. Druckplatten, beschichtet mit einem Gemisch nach Anspruch 6.

9. Verfahren zur Herstellung der Bindemittel gemäß Anspruch 1 **dadurch gekennzeichnet, daß** entweder VinylalkoholNinylamincopolymere mit Halogeniden oder Anhydriden organischer Carbonsäuren und anschliessend mit aliphatischen Aldehyden umgesetzt werden, oder daß Copolymere aus Vinylestern mit ungesättigten Monomeren, die eine Carboxylgruppe enthalten, teilweise verseift werden, und die Verseifungsprodukte mit aliphatischen Aldehyden und anschließend mit Aminen umgesetzt werden.

## Claims

1. A binder containing the units A, B, C and D, wherein A is present in an amount of from 0.1 to 25 wt. % and is represented by the following formula 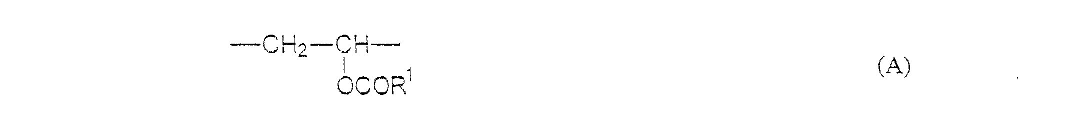 wherein R¹ is a hydrogen atom or a C₁-C₄ aliphatic hydrocarbon or an aromatic residue, B is present in an amount of from 10 to 50 wt. % and is represented by the following formula 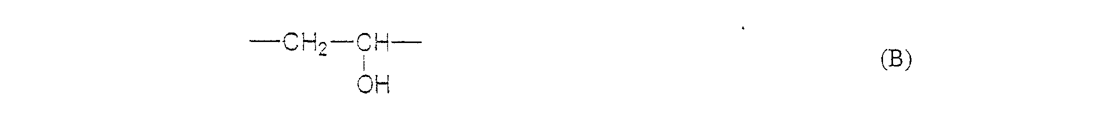 C is present in an amount of from 10 to 80 wt. % and is represented by the following formula 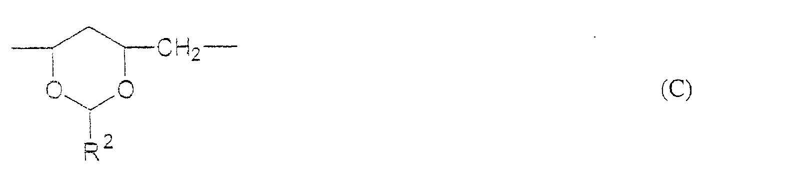 wherein R² is a hydrogen atom, alkyl, aralkyl, or aryl and this unit comprising different residues R² can be contained several times independently of one another, and D is present in an amount of from 1 to 40 wt. % and is represented by the following formula 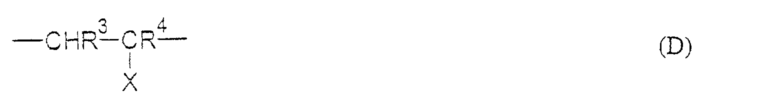 wherein X represents either the group -NHCO-R⁵ or -CO-NHR⁶ and R³ and R⁴ are hydrogen atoms or C₁-C₁₀ alkyl residues, R⁵ is a hydrogen atom or a C₁-C₁₀ aliphatic saturated or unsaturated hydrocarbon residue, which may be substituted by a carboxyl group, or an aromatic hydrocarbon residue, which may be substituted by a carboxyl group and other substituents, and R⁶ is a C₁-C₆ hydrocarbon residue, which may be substituted by one or more hydroxyl, ether or amino, monoalkylamino, dialkylamino or carboxyl groups, the alkyl groups of the substituted amino group or of the ether group containing 1 to 3 carbon atoms, or an aromatic hydrocarbon residue containing at least one carboxyl or sulfonic acid group, but also other substituents, and said unit may be contained several times independently of one another, each comprising different residues R⁵ or R⁶.

2. A photosensitive composition containing:
(i) a diazonium polycondensation product or
a radical-polymerizable system consisting of photoinitiators and unsaturated compounds which are radical-polymerizable, or a hybrid system consisting of a diazonium polycondensation product and a radical-polymerizable system consisting of photoinitiators and unsaturated compounds which are radical-polymerizable, and
(ii) a binder according to claim 1.

3. The composition according to claim 2, containing as a photosensitive component a polycondensation product of 3-methoxy-diphenylamine-4-diazonium sulfate and 4,4'-bis-methoxymethyldiphenyl ether, which has been precipitated from an aqueous solution as organic sulfonate, tetrafluoroborate, hexafluorophosphate, hexafluoroantimonate or hexafluoroarsenate.

4. The composition according to claim 2, containing as a photosensitive component a radical forming photoinitiator or mixtures of photoinitiators and co-initiators, making the composition sensitive to wavelengths in the range of 300 to 800 nm, as well as radical-polymerizable components comprising unsaturated groups.

5. The composition according to claim 2, containing as photosensitive components a diazo polycondensation product according to claim 3 in combination with a radical photoinitiator system as well as radical-polymerizable components according to claim 4.

6. The composition according to any one of claims 2 to 5, additionally containing one or more exposure indicators, one or more dyes for increasing the image contrast, as well as one or more acids for stabilizing the photosensitive composition.

7. Use of a composition according to claim 6 for the preparation of printing plates.

8. Printing plates, coated with a mixture according to claim 6.

9. A method of preparing the binders according to claim 1, **characterized in that** either vinyl alcohol/vinyl amine copolymers are reacted with halides or anhydrides of organic carboxylic acids and then with aliphatic aldehydes, or that copolymers of vinyl esters with unsaturated monomers containing a carboxyl group are partially saponified and the saponification products are reacted with aliphatic aldehydes and then with amines.

## Revendications

1. Liants, contenant les motifs A, B, C et D, dans lesquels A est présent en une quantité en pourcentage de 0,1 à 25 % en poids et correspond à la formule 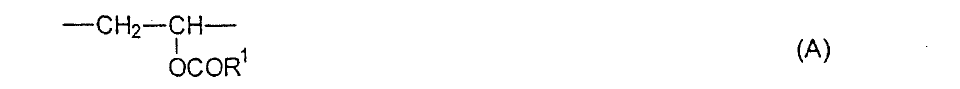 dans laquelle R¹ est un atome d'hydrogène ou un groupe hydrocarboné aliphatique ayant de 1 à 4 atomes de carbone ou un groupe aromatique, B est présent en une quantité en pourcentage de 10 à 50 % en poids et correspond à la formule 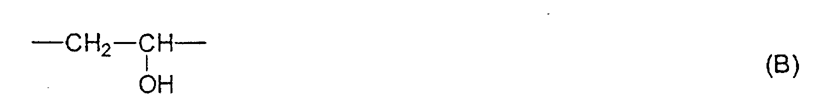 C est présent en une quantité en pourcentage de 10 à 80 % en poids et correspond à la formule 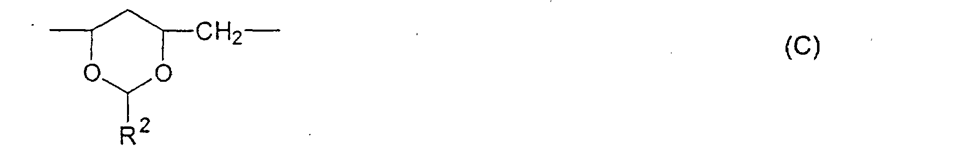 dans laquelle R² est un atome d'hydrogène, un groupe alkyle, aralkyle ou aryle, et ce motif peut être contenu plusieurs fois dans le composé avec différents groupes R² indépendants les uns des autres, et D est présent en une quantité en pourcentage de 1 à 40 % en poids et correspond à la formule 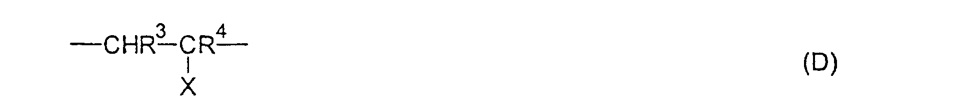 dans laquelle X représente soit le groupe -NHCO-R⁵ ou -CO-NHR⁶ et R³ et R⁴ sont des atomes d'hydrogène ou des groupes alkyle ayant un nombre d'atomes de carbone compris entre 1 et 10,
R⁵ représente un atome d'hydrogène ou un groupe hydrocarboné aliphatique saturé ou insaturé ayant de 1 à 10 atomes de carbone, qui peut être substitué par un groupe carboxyle, ou un groupe hydrocarboné aromatique qui peut être substitué par un groupe carboxyle et d'autres substituants, et
R6 représente un groupe hydrocarboné ayant de 1 à 6 atomes de carbone, qui peut être substitué par un
ou plusieurs groupes hydroxyle, éther ou amino, monoalkylamino, dialkylamino ou carboxyle, dans lequel les groupes alkyle du groupe amino substitué ou du groupe éther contiennent de 1 à 3 atomes de carbone, ou un groupe hydrocarboné aromatique, qui contient au moins un reste d'acide carboxylique ou sulfonique, mais également d'autres substituants, et ce motif peut être contenu plusieurs fois dans le composé avec différents groupes R⁵ ou R⁶ respectivement indépendants les uns des autres.

2. Composition photosensible, contenant :
(i) un produit de polycondensation de diazonium ou un système polymérisable par voie radicalaire constitué de photoinitiateurs et de composés insaturés, qui sont polymérisables par voie radicalaire ou un système hybride constitué d'un produit de polycondensation de diazonium et d'un système polymérisable par voie radicalaire constitué de photoinitiateurs et de composés insaturés, qui sont polymérisables par voie radicalaire, et
(ii) un liant selon la revendication 1.

3. Composition selon la revendication 2, dans laquelle est contenu comme composant photosensible un produit de polycondensation de sulfate de 3-méthoxydiphénylamine-4-diazonium et de 4,4'-bis-méthoxyméthyldiphényléther, qui a été précipité en solution aqueuse sous la forme de sulfonate, tétrafluoroborate, hexafluorophosphate ou hexafluoroantimoniate ou hexafluoroarsénate organique.

4. Composition selon la revendication 2, dans laquelle sont contenus comme composants photosensibles un photoinitiateur ou des mélanges de photoinitiateurs et de co-initiateurs générateurs de radicaux, qui sensibilisent la composition pour la gamme de longueur d'onde variant de 300 à 800 nm, et des composants polymérisables par voie radicalaire avec des groupes insaturés.

5. Composition selon la revendication 2-, dans laquelle sont contenus comme composants photosensibles un produit de polycondensation diazoïque selon la revendication 3 en combinaison avec un système de photoinitiateurs radicalaires ainsi que dés constituants polymérisables par voie radicalaire selon la revendication 4.

6. Composition selon l'une des revendications 2 à 5, dans laquelle sont contenus en supplément un ou plusieurs indicateurs d'insolation, un ou plusieurs colorants pour augmenter le contraste de l'image, et un ou plusieurs acides pour la stabilisation de la composition photosensible.

7. Utilisation d'une composition selon la revendication 6 pour la fabrication de plaques d'impression.

8. Plaques d'impressions, recouvertes avec un mélange selon la revendication 6.

9. Procédé pour la préparation des liants selon la revendication 1, **caractérisé en ce qu'**on met à réagir soit des copolymères d'alcool de vinyle et de vinylamine avec des halogénures ou des anhydrides d'acides carboxyliques organiques et ensuite avec des aldéhydes aliphatiques, ou **en ce qu'**on saponifie partiellement des copolymères d'esters de vinyle avec des monomères insaturés, qui contiennent un groupe carboxyle, et **en ce qu'**on met à réagir les produits de saponification avec des aldéhydes aliphatiques et ensuite avec des amines.
